# EUROPEAN PATENT APPLICATION

(11) **EP 4 383 984 A1**
(43) Date of publication of application: **12.06.2024**
(21) Application number: 23213953.5
(22) Date of filing: 04.12.2023
(51) Int. Cl.: H10K 59/38, H10K 59/60, H10K 59/80

(54) **SEMICONDUCTOR DEVICE, DISPLAY DEVICE, PHOTOELECTRIC CONVERSION DEVICE, ELECTRONIC APPARATUS, ILLUMINATION DEVICE, MOVING BODY, WEARABLE DEVICE, AND MANUFACTURING METHOD OF SEMICONDUCTOR DEVICE**

(30) Priority: 07.12.2022 JP 2022195861
(71) Applicant: CANON KABUSHIKI KAISHA, Tokyo 146-8501 (JP)
(72) Inventor: NOZAKI, Yuto, Tokyo, 146-8501 (JP); KAWAMURA, Yoshihisa, Tokyo, 146-8501 (JP); ABUKAWA, Kotaro, Tokyo, 146-8501 (JP); NAKATA, Norihiko, Tokyo, 146-8501 (JP)
(74) Representative: TBK

(57) **Abstract**

A semiconductor device (101) that comprises, on a substrate (100), a pixel region (104) where a plurality of pixels (201) are arranged, and a monitor region (106) is provided. In the pixel region (104), a plurality of lenses (212) are arranged on an underlayer (309) such that the underlayer (309) is not exposed, and in the monitor region (106), a plurality of monitor lenses (222) are arranged on the underlayer (309). The plurality of monitor lenses (222) include a pair of monitor lenses arranged such that the underlayer (309) is not exposed between two monitor lenses (222) adjacent to each other, and a pair of monitor lenses arranged with an exposed portion (319) where the underlayer (309) is exposed between two monitor lenses (222) adjacent to each other.

## Description

### BACKGROUND OF THE INVENTION

### Field of the Invention

The present invention relates to a semiconductor device, a display device, a photoelectric conversion device, an electronic apparatus, an illumination device, a moving body, a wearable device, and a manufacturing method of the semiconductor device.

### Description of the Related Art

In a semiconductor device in which a plurality of pixels each including a photoelectric conversion element or a light emitting element are arranged, a micro lens array may be provided to improve sensitivity or light emitting efficiency. Japanese Patent Laid-Open No. 2006-253464 describes a solid-state image sensor which uses, to suppress a decrease in sensitivity caused by miniaturization of pixels, a gapless structure in which a region (gap) where no lens is formed is not provided between lenses of the microlens array.

### SUMMARY OF THE INVENTION

If there is a gap between the lenses of the microlens array, process control of the surface shape of the lens can be easily performed by measuring the surface shape of the lens using an Atomic Force Microscope (AFM) or the like with the gap portion as a reference. On the other hand, in a case of the gapless structure, since no gap is provided between the lenses, a reference point cannot be set, so the height of the lens cannot be measured using the AFM.

Some embodiments of the present invention provide a technique advantageous in highly accurate control of the surface shape of a lens.

The present invention in its first aspect provides a semiconductor device as specified in claims 1 to 15.

The present invention in its second aspect provides a display device as specified in claim 16.

The present invention in its third aspect provides a photoelectric conversion device as specified in claim 17.

The present invention in its fourth aspect provides an electronic apparatus as specified in claim 18.

The present invention in its fifth aspect provides an illumination device as specified in claim 19.

The present invention in its sixth aspect provides a moving body as specified in claim 20.

The present invention in its seventh aspect provides a wearable device as specified in claim 21.

The present invention in its eighth aspect provides a manufacturing method of a semiconductor device as specified in claim 22.

Further features of the present invention will become apparent from the following description of exemplary embodiments (with reference to the attached drawings).

### BRIEF DESCRIPTION OF THE DRAWINGS

Fig. 1 is a view showing an example of the arrangement of a semiconductor device according to an embodiment;
Fig. 2A is a plan view showing an example of the arrangement of a pixel region of the semiconductor device of a comparative example;
Fig. 2B is a sectional view showing the example of the arrangement of the pixel region of the semiconductor device of the comparative example;
Fig. 3A is a plan view showing an example of the arrangement of the pixel region of the semiconductor device shown in Fig. 1;
Fig. 3B is a sectional view showing the example of the arrangement of the pixel region of the semiconductor device shown in Fig. 1;
Fig. 4 is a plan view showing an example of the arrangement of a monitor region of the semiconductor device shown in Fig. 1;
Fig. 5 is a sectional view showing the example of the arrangement of the monitor region of the semiconductor device shown in Fig. 4;
Fig. 6 is a plan view showing an example of the arrangement of the monitor region of the semiconductor device shown in Fig. 1;
Fig. 7 is a sectional view showing the example of the arrangement of the monitor region of the semiconductor device shown in Fig. 6;
Fig. 8 is a plan view showing an example of the arrangement of the monitor region of the semiconductor device shown in Fig. 1;
Fig. 9 is a sectional view showing the example of the arrangement of the monitor region of the semiconductor device shown in Fig. 8;
Fig. 10 is a plan view showing an example of the arrangement of the pixel region of the semiconductor device shown in Fig. 1;
Fig. 11 is a sectional view showing the example of the arrangement of the pixel region of the semiconductor device shown in Fig. 10;
Fig. 12 is a plan view showing an example of the arrangement of the monitor region of the semiconductor device shown in Fig. 1;
Fig. 13 is a sectional view showing the example of the arrangement of the monitor region of the semiconductor device shown in Fig. 12;
Figs. 14A and 14B are sectional views each showing an example of the arrangement of a pixel of the semiconductor device shown in Fig. 1;
Figs. 15A to 15C are views showing an example of an image forming device using the semiconductor device according to the embodiment;
Fig. 16 is a view showing an example of a display device using the semiconductor device according to the embodiment;
Fig. 17 is a view showing an example of a photoelectric conversion device using the semiconductor device according to the embodiment;
Fig. 18 is a view showing an example of an electronic apparatus using the semiconductor device according to the embodiment;
Figs. 19A and 19B are views each showing an example of a display device using the semiconductor device according to the embodiment;
Fig. 20 is a view showing an example of an illumination device using the semiconductor device according to the embodiment;
Fig. 21 is a view showing an example of a moving body using the semiconductor device according to the embodiment; and
Figs. 22A and 22B are views each showing an example of a wearable device using the semiconductor device according to the embodiment.

### DESCRIPTION OF THE EMBODIMENTS

Embodiments will be described in detail below with reference to the accompanying drawings. Note, the following embodiments are not intended to limit the scope of the claimed invention. Multiple features are described in the embodiments, but limitation is not made an invention that requires all such features, and multiple such features may be combined as appropriate. Furthermore, in the attached drawings, the same reference numerals are given to the same or similar configurations, and redundant description thereof is omitted.

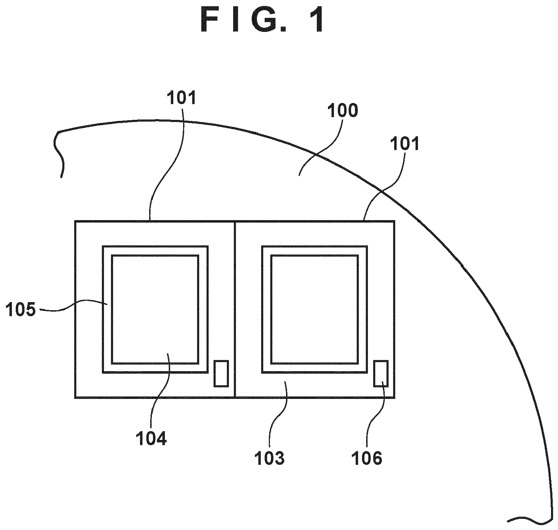

With reference to Figs. 1 to 13, a semiconductor device according to an embodiment of the present disclosure will be described. Fig. 1 is a plan view showing an example of the arrangement of a semiconductor device 101 according to the embodiment. Fig. 1 shows the semiconductor device 101 formed on a substrate 100 using a semiconductor wafer. For the sake of descriptive convenience, Fig. 1 shows two semiconductor devices 101 formed on the substrate 100. However, in practice, more semiconductor devices 101 may be formed on one substrate 100. For example, a semiconductor wafer made of silicon or the like can be used for the substrate 100.

Each semiconductor device 101 can include a pixel region 104 where a plurality of pixels are arranged, and a peripheral region 103. The plurality of pixels arranged in the pixel region 104 may include, for example, photoelectric conversion elements. Each of the plurality of pixels arranged in the pixel region 104 may include the photoelectric conversion element, or at least some of the plurality of pixels may each include the photoelectric conversion element. If the pixel arranged in the pixel region 104 includes the photoelectric conversion element, the semiconductor device 101 can also be called a photoelectric conversion device. The plurality of pixels arranged in the pixel region 104 may include, for example, light emitting elements. Each of the plurality of pixels arranged in the pixel region 104 may include the light emitting element, or at least some of the plurality of pixels may each include the light emitting element. If the pixel arranged in the pixel region 104 includes the light emitting element, the semiconductor device 101 can also be called a light emitting device. Hereinafter, a description will be given assuming that the pixel arranged in the pixel region 104 includes the light emitting element. The semiconductor device 101 may be a device in which, for example, a self-light emitting element such as an organic electroluminescence (EL) element, an inorganic EL element, or a light emitting diode is used as the light emitting element in the pixel. Alternatively, for example, the semiconductor device 101 may be a so-called liquid crystal display device in which a liquid crystal element or the like is used for the pixel.

In the semiconductor device 101, a dummy pixel region 105 where a dummy pixel is arranged on the substrate 100 may further be arranged so as to be adjacent to the pixel region 104. The dummy pixel arranged in the dummy pixel region 105 may not include the light emitting element. Alternatively, for example, the dummy pixel may include the light emitting element but have no configuration for causing the light emitting element to emit light. Further, for example, the dummy pixel may have a configuration similar to that of the pixel arranged in the pixel region 104, but be configured not to be used as the pixel for emitting light in the semiconductor device 101. In contrast to the dummy pixel region 105 arranged with the dummy pixel as described above, the pixel region 104 can be called an effective pixel region.

In the peripheral region 103, a drive circuit for driving the pixels arranged in the pixel region 104, and the like can be arranged. In the pixel region 103, a signal processing circuit for processing signals output from the pixel region 104 may also be arranged. Further, for example, a terminal (pad) for connection to an external circuit arranged outside the semiconductor device 101, or the like may be provided in the peripheral region 103.

In this embodiment, a monitor region 106 is further arranged in the peripheral region 103 of the semiconductor device 101. In the monitor region 106, a monitor lens for controlling the surface shape of a lens (microlens) arranged in the pixel region 104 is arranged. For example, a plurality of lenses can be arranged in the pixel region 104 so as to correspond to the plurality of pixels, respectively. In this embodiment, it is possible to control the shape of the lens arranged in the pixel region 104 by using the monitor lens arranged in the monitor region 106 provided separately from the pixel region 104. Therefore, even if the monitor lens is damaged when measuring the shape of the monitor lens, the possibility of damaging the lens arranged in the pixel region 104 is very small. That is, when the monitor lens for controlling the shape of the lens is arranged in the monitor region 106 outside the pixel region 104 in the manufacturing process or the like of the semiconductor device 101, an influence on an image (picture, character, or the like) displayed in the pixel region 104 is significantly reduced. Although details will be described later, if a gapless structure is employed in the pixel region 104, in which a region (gap) where no lens is formed is not provided between the lenses of the microlens array, it can be difficult to measure the shape of the lens itself. Hence, in this embodiment, the monitor region 106 is arranged.

The monitor region 106 may be arranged in the dummy pixel region 105. In other words, a part of the dummy pixel region 105 may be the monitor region 106. If the monitor region 106 is arranged in the dummy pixel region 105 adjacent to the pixel region 104, as compared to a case in which the monitor region 106 is away from the pixel region 104, advantages as follows can be obtained. Since the dummy pixel region 105 is close to the pixel region 104, the structure between the substrate 100 and an underlayer on which the monitor lens is arranged is often similar to the structure between the substrate 100 and an underlayer on which the lens is arranged in the pixel region 104. Accordingly, the focus position during exposure and the degree of reflection of exposure light from the underlying structure upon patterning the monitor lens itself or a pattern for forming the monitor lens using a photolithography process or the like are similar to conditions in the pixel region 104. Hence, the monitor lens having a shape more similar to the shape of the lens formed in the pixel region 104 can be formed in the monitor region 106. In a display device, the pixel in the monitor region 106 is a pixel that does not contribute to display. The pixel in the monitor region 106 does not emit light based on display data. The pixel in the monitor region 106 can have a configuration similar to that of the pixel in the pixel region 104, but is configured not to receive display data so it does not contribute to display. On the other hand, in a case in which display data is input to the pixel in the monitor region 106, the pixel in the monitor region 106 is configured not to include a part of the pixel circuit or a part of the pixel structure so it does not contribute to display. In an image capturing device, the pixel in the monitor region 106 is a pixel that does not contribute to image capturing. An example of not contributing to image capturing is similar to the example described for the display device.

Next, as a comparative example for this embodiment, a description will be given for the lenses and a process control method of the shape of the lens in a case in which a gap where no lens is formed is provided between the lenses of the lens array in the pixel region 104. After the comparative example, a description will be given for the lenses with the gapless structure in which a gap where no lens is formed is not provided between the lenses, a problem in process control of the shape of the lens, and process control of the shape of the lens implemented by this embodiment.

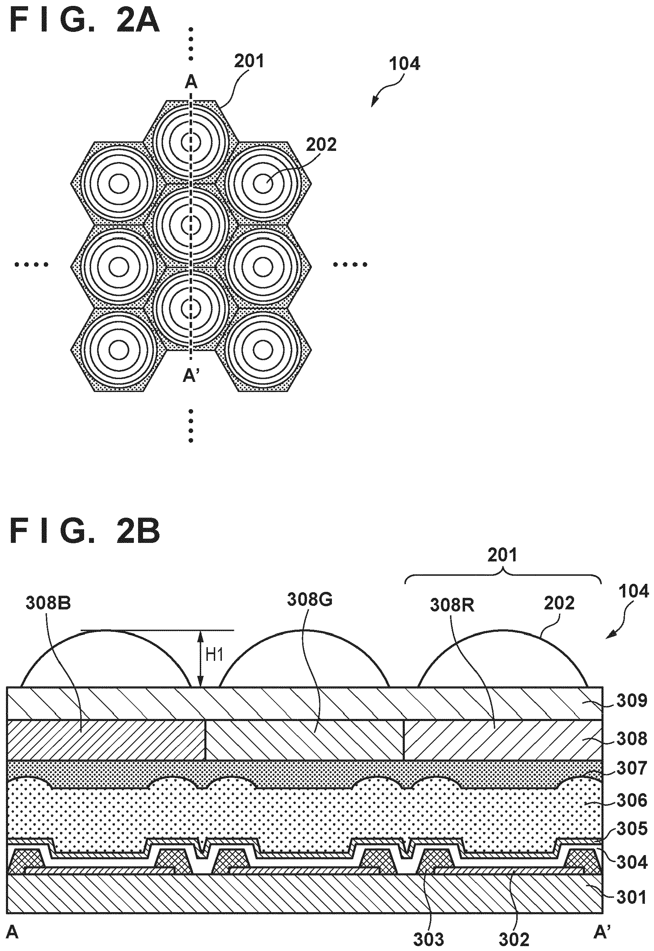

Figs. 2A and 2B are a plan view and a sectional view, respectively, for explaining a pixel 201 arranged in the pixel region 104 of the semiconductor device 101 of a comparative example. Fig. 2A shows the planar structure of lenses 202 of the comparative example in which a gap exists between two lenses 202 adjacent to each other. Fig. 2A shows a part of the pixel region 104, and a plurality of the pixels 201 are arranged at a predetermined pitch in a two-dimensional array in the pixel region 104. Further, a plurality of the lenses 202 are arranged at a predetermined pitch such that one lens 202 corresponds to one pixel 201. It can also be said that a lens array (microlens array) is arranged in the pixel region 104. In the arrangement shown in Fig. 2A, the pixel 201 has a hexagonal shape, but the present invention is not limited to this. In a planar view, the pixel 201 may have a rectangular shape such as a square or a rectangle, or may have a polygonal shape. Here, a planar view in this specification indicates a field of view, shown in Fig. 2A, with respect to the surface of the substrate 100 on which the pixel 201 including the lens 202 and the like is formed. The pitch (interval) at which the lenses 202 are arranged can be defined by, for example, the distance between the tops of the lenses 202. Alternatively, for example, in the planar view, the center of the lens 202 is set at the position of the geometric centroid of the shape of the lens 202 defined by the outer edge of each lens 202. The pitch (interval) at which the lenses 202 are arranged may be defined by the distance between the centers of the lenses 202 in the planar view.

Fig. 2B is a sectional view taken along a line A - A' shown in Fig. 2A. In the arrangement shown in Fig. 2B, the pixel 201 arranged in the pixel region 104 can include a structure 301, a lower electrode 302, an insulating layer 303, an organic layer 304 including a light emitting layer, an upper electrode 305, a protection layer 306, a planarizing layer 307, a color filter layer 308, and an underlayer 309.

The structure 301 can include a switching element, such as a transistor for driving the pixel 201, formed on the substrate 100, an insulating layer, a wiring pattern layer, and a conductor such as a contact plug. The structure 301 can include, for example, an insulating film containing silicon oxide or the like, and a wiring pattern containing copper, aluminum, or the like as a main component.

The lower electrode 302 is arranged on the structure 301. In this specification, "on" indicates the direction from the substrate 100 (structure 301) to the lens 202. The lower electrode 302 can function as an anode or cathode of the light emitting element included in the pixel 201. The lower electrode 302 may also have a role as a reflection layer for light emitted from a light emitting layer included in the organic layer 304. Therefore, a metal such as aluminum or silver having a large reflectance, or an alloy thereof may be used for the lower electrode 302.

The insulating layer 303 can be formed so as to cover the end portion of the lower electrode 302. The insulating layer 303 can also be called a pixel separation film or a bank. A so-called silicon oxide based material such as silicon nitride, silicon oxynitride, or silicon oxide may be used for the insulating layer 303. The arrangement of the lower electrode 302 and the lower electrode 302 exposed in an opening portion provided in the insulating layer 303 can define the light emission position of each pixel 201.

The organic layer 304 is arranged so as to cover the lower electrode 302 and the insulating layer 303. The organic layer 304 may be formed by a plurality of layers including the light emitting layer. The plurality of layers may include a hole injection layer, a hole transport layer, an electron block layer, the light emitting layer, a hole block layer, an electron transport layer, an electron injection layer, and the like.

The upper electrode 305 is arranged on the organic layer 304. The upper electrode 305 can function as the cathode or anode of the light emitting element included in the pixel 201. The upper electrode 305 is a conductive layer with translucency which transmits light emitted from the light emitting layer included in the organic layer 304. An alloy containing silver or magnesium as a main component, or a transparent conductive material such as indium tin oxide (ITO) can be used for the upper electrode 305. The organic layer 304 and the upper electrode 305 may be shared by the plurality of pixels 201 as shown in Fig. 2B.

The protection layer 306 is arranged on the upper electrode 305. The protection layer 306 is arranged to suppress diffusion, to the organic layer 304 and the structure 301, of water from the outside of the semiconductor device 101 and impurities from the color filter layer 308 and the like. For example, silicon nitride, silicon oxide, aluminum oxide, or the like can be used for the protection layer 306.

The planarizing layer 307 is arranged on the protection layer 306. The planarizing layer 307 is a layer for planarizing unevenness of the upper surface of the protection layer 306. For example, an organic material can be used for the planarizing layer 307. For example, a resin that can be spin-coated may be used for the planarizing layer 307. If unevenness of the upper surface of the protection layer 306 is not large, or if unevenness of the upper surface of the protection layer 306 can be planarized using a polishing process or the like, the planarizing layer 307 may not be provided.

The color filter layer 308 is arranged on the planarizing layer 307. The color filter layer 308 may include a plurality of kinds of filters each of which transmits (or absorbs) light of a specific frequency band. For example, in the pixel region 104, the filters, each of which transmits a primary color, may be arranged such that the filter of one color corresponds to one pixel 201. As shown in Fig. 2B, the color filter layer 308 may include, for example, three kinds of filters including a filter 308B which transmits blue light, a filter 308G which transmits green light, and a filter 308R which transmits red light.

The lens 202 is provided on the color filter layer 308 via the underlayer 309. The underlayer 309 can be a planarizing layer for planarizing the surface of the layer (for example, the upper surface of the color filter layer 308) below the underlayer 309. A material similar to that of the planarizing layer 307 may be used for the underlayer 309. If unevenness of the upper surface of the color filter layer 308 is not large, the underlayer 309 may not be provided.

Next, process control of the shape of the lens 202 will be described. In the lens 202, the upper surface of the underlayer 309 is set as a reference point, and the difference between the height of the reference point and the height of the top (vertex) of the lens 202 is defined as a height H1 of the lens 202. The height H1 of the lens 202 can be measured by, for example, scanning the surface including the lens 202 and the underlayer 309 using an Atomic Force Microscope (AFM), and thus the process control can be executed.

In process control, for example, the lens 202 in the pixel region 104 may be measured directly. Alternatively, as has been described above, in order to suppress the influence of damage during measuring the shape of the lens 202, the lens 202 arranged in the dummy pixel region 105 may be measured. Alternatively, for example, the shape of the monitor lens formed in the monitor region 106 arranged in the peripheral region 103 by using a mask pattern similar to the mask pattern for the lens 202 may be measured.

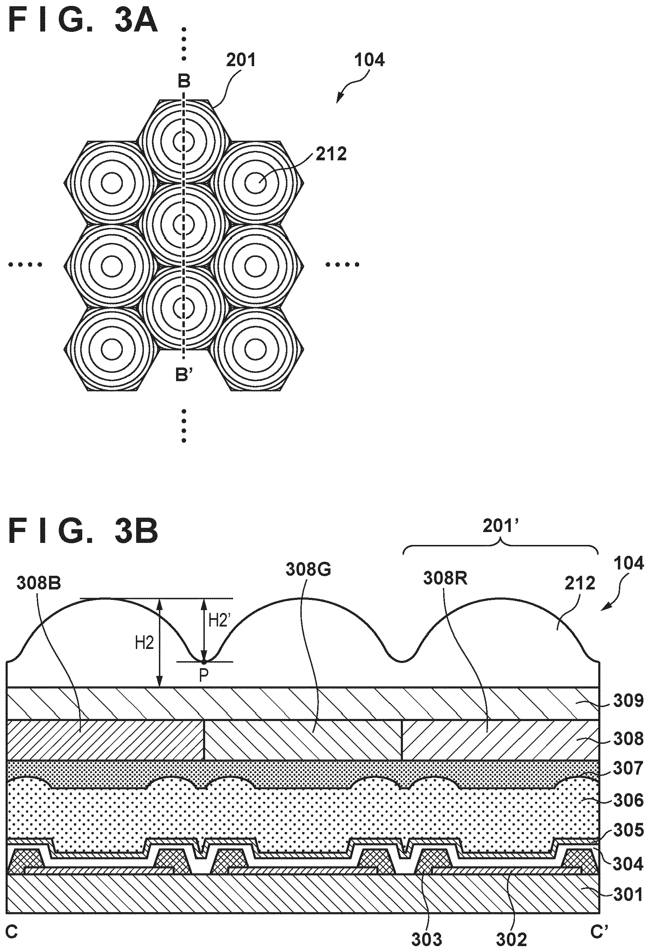

Next, a description will be given for a problem in performing process control of the shape of the lens in a case of using the gapless structure in which no gap exists between two lenses adjacent to each other in the pixel region 104. Figs. 3A and 3B are a plan view and a sectional view, respectively, for explaining the pixel 201 arranged in the pixel region 104 of the semiconductor device 101 according to this embodiment. Fig. 3A shows the planar structure of the lenses 212 of this embodiment in which no gap exists between two lenses 212 adjacent to each other. More specifically, Fig. 3A shows a part of the pixel region 104, and the plurality of pixels 201 are arranged at a predetermined pitch in a two-dimensional array in the pixel region 104. Further, a plurality of the lenses 212 are arranged at a predetermined pitch on the underlayer 309 such that the underlayer 309 is not exposed and one lens 212 corresponds to one pixel 201. Each lens 212 is in contact with the adjacent lens 212. In the planar view, there is no region where the underlayer 309 under the lens is exposed in the spacing between the lenses 212. Here, the pitch (interval) at which the lenses 212 are arranged can be defined by, for example, the distance between the tops of the lenses 212. Alternatively, for example, the position of the geometric centroid of the shape of the lens 212 in the planar view, which is defined while setting the valley between the lenses 212 adjacent to each other as the outer edge of each lens 212, is set as the center of the lens 212. The pitch (interval) at which the lenses 212 are arranged may be defined by the distance between the centers of the lenses 212 in the planar view.

Fig. 3B is a sectional view taken along a line B - B' shown in Fig. 3A. The arrangement between the lens 212 and the substrate 100 (structure 301) may be similar to the arrangement described using Fig. 2B described above, and a description thereof will be omitted here.

Here, consider process control of the shape of the lens 212. In the lens 212, the upper surface of the underlayer 309 is set as a reference point, and the difference between the height of the reference point and the height of the top of the lens 212 is defined as a height H2 of the lens 212. For example, in process control of the shape of the lens 212, as in the above description, the surface of the lens 212 is scanned using an AFM to measure unevenness of the lens 212. In this case, since the underlayer 309 is not exposed in the surface to be measured, the upper surface of the underlayer 309 cannot be used as the reference point. If a point P indicating the valley portion between the lenses 212 adjacent to each other is set as the reference point for the height upon measuring the lens 212, the difference between the height of the point P and the height of the top of the lens 212 is indicated by H2' as shown in Fig. 3B. In this case, H2 ≠ H2', so that a value different from the actual height H2 of the lens 212 is measured. Hence, as shown in Figs. 3A and 3B, there is a problem that, if the lens 212 is arranged such that the underlayer 309 is not exposed between the lenses 212 adjacent to each other, the height H2 of the lens 212 cannot be accurately measured. As miniaturization and high integration of pixels progress, the gapless structure is likely to be employed. For display with higher resolution in the semiconductor device 101, the process control of the shape of the lens 212 can become more important.

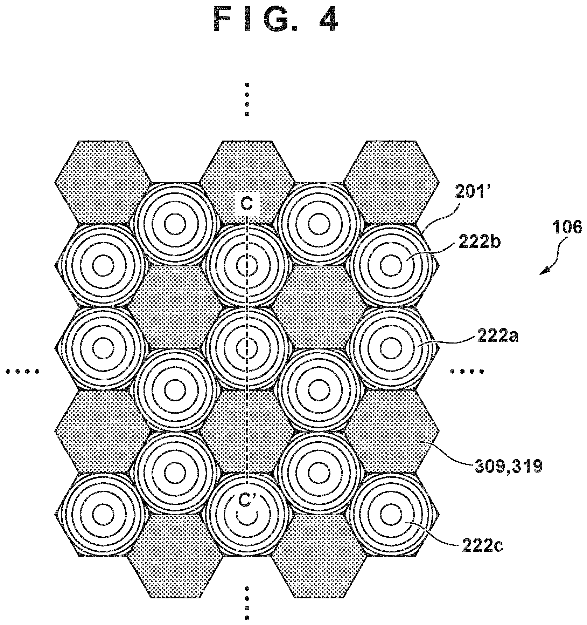

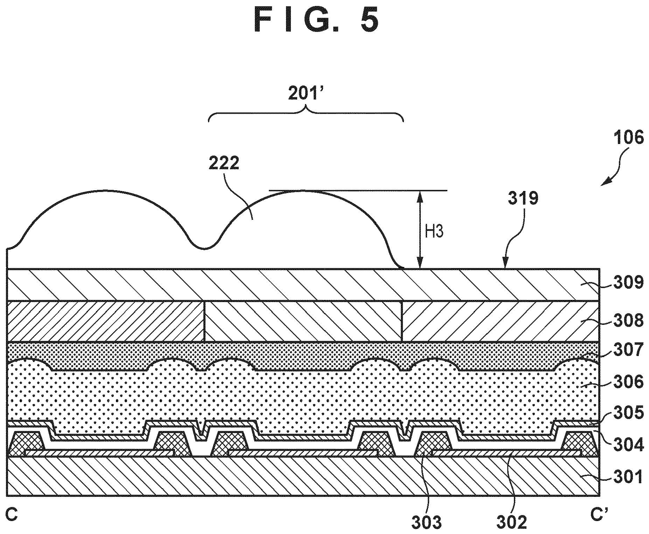

Next, a description will be given for the arrangement of this embodiment for addressing the problem of not being capable of accurately measuring the height H2 of the lens 212 using the AFM in a case of employing the gapless structure of the lens 212 in the pixel region 104. Figs. 4 and 5 are a plan view and a sectional view, respectively, for explaining a monitor lens 222 arranged in the monitor region 106 of the semiconductor device 101 according to this embodiment. Fig. 4 shows a part of the monitor region 106, and Fig. 5 is a sectional view taken along a line C - C' shown in Fig. 4.

In the monitor region 106, a plurality of the monitor lenses 222 are arranged on the underlayer 309. The plurality of monitor lenses 222 include a pair of monitor lenses (for example, a pair of a monitor lens 222a and a monitor lens 222b) arranged such that the underlayer 309 is not exposed between two monitor lenses 222 adjacent to each other, and a pair of monitor lenses (for example, the monitor lens 222a and a monitor lens 222c) arranged with an exposed portion 319 where the underlayer 309 is exposed between two monitor lenses 222 adjacent to each other. That is, in the planar view, the plurality of monitor lenses 222 and a plurality of the exposed portions 319 are two-dimensionally arrayed in the monitor region 106. Further, parts of the underlayer 309 under the monitor lenses 222 are exposed in the monitor region 106.

In this embodiment, in process control of the shape of the lens 212, the height of the monitor lens 222 can be measured. The shape of the monitor lens 222 can be measured by, for example, scanning unevenness of the surface including the monitor lens 222 and the exposed portion 319 in the monitor region 106 by using an AFM. In this case, unlike the lens 212 in the pixel region 104, since the exposed portion 319 is provided, the exposed portion 319 can be used as the reference point for the height in the AFM measurement. The difference between the height of the reference point and the height of the top of the monitor lens 222 is a height H3 of the monitor lens 222 as shown in Fig. 5, so that the height of the monitor lens 222 can be accurately measured.

The monitor lens 222 is arranged to monitor the shape of the lens 212 in the pixel region 104. Therefore, if the monitor lens 222 has a shape similar to the shape of the lens 212, the accuracy of the process control can be improved. Hence, the mask pattern for forming the monitor lens 222 may include the same mask pattern as the mask pattern for forming the plurality of lenses 212 arranged in the pixel region 104. For example, the mask pattern for forming the monitor lens 222 may be partially same as the mask pattern for forming the plurality of lenses 212 arranged in the pixel region 104. Accordingly, for example, the arranging interval of two monitor lenses, among the plurality of monitor lenses 222, adjacent to each other arranged such that the underlayer 309 is not exposed (for example, the interval between the monitor lens 222a and the monitor lens 222b) may be equal to the arranging pitch of the plurality of lenses 212 arranged in the pixel region 104. Further, for example, in the monitor region 106, as shown in Fig. 5, the arrangement from the structure 301 to the underlayer 309 may be similar to that in the pixel region 104. That is, a monitor pixel 201' where the monitor lens 222 is arranged may have an arrangement similar to that of the pixel 201 where the lens 212 is arranged. When the arrangement of the substrate 100 (structure 301) is more similar to that in the pixel region 104 than the monitor lens 222, the conditions of the photolithography process for forming the monitor lens 222 are similar to those for the lens 212, so that the monitor lens 222 having a shape similar to the shape of the lens 212 can be formed. However, the present invention is not limited to this. In the monitor region 106, at least a part of the arrangement from the structure 301 to the underlayer 309 (for example, a part of the arrangement of the structure 301 or the like) may be different from that in the pixel region 104. Further, for example, components of the pixel 201 such as the lower electrode 302, the organic layer 304, and the upper electrode 305 may not be formed in the monitor region 106. Here, the arranging interval of the monitor lenses 222 may be, for example, the distance between the tops of the monitor lenses 222. Alternatively, for example, the position of the geometric centroid of the shape of the lens 212 in the planar view, which is defined while setting the valley between the monitor lenses adjacent to each other as the outer edge of each monitor lens 222, is set as the center of the monitor lens 222. The arranging interval of the monitor lenses 222 may be the distance between the centers of the monitor lenses 222 in the planar view.

As has been described above, the monitor lens 222 can have a shape similar to the shape of the lens 212. However, the monitor lens 222 is arranged at a position away from the lens 212 arranged in the pixel region 104. In addition, the exposed portion 319 is arranged in the monitor region 106. Due to their influences, even if the monitor lens 222 is formed using the same mask pattern as the lens 212, the monitor lens 222 may not have exactly the same shape as the lens 212. Here, the influence of arranging the exposed portion 319 can include the optical influence of exposure light from the exposed portion 319 during exposure of the monitor lens 222, the influence of the difference in stress between the adjacent lenses caused by nonuniformity in the shape of the monitor lens 222, and the like. However, the correlation between the shape of the lens 212 and the shape of the monitor lens 222 is acquired in advance using a measurement method other than the AFM during trial production or the like. For example, the sectional shape of the lens 212 and that of the monitor lens 222 are acquired in advance using a Transmission Electron Microscope (TEM). With this, the monitor lens 222 can be used for monitoring the shape of the lens 212.

Next, a manufacturing method of the semiconductor device 101 according to this embodiment will be described. In this embodiment, the plurality of monitor lenses 222 arranged in the monitor region 106 can be formed at the same time as the plurality of lenses 212 arranged in the pixel region 104. Here, a case will be described in which the monitor lens 222 is manufactured at the same time as the lens 212 by a tone exposure method. As an example of the tone exposure method, a case of using an area tone mask will be described. The area tone mask is a method of creating tones in exposure light by changing the density of a minute light shielding portion that cannot be resolved by an exposure device, or by changing the area of the minute light shielding portion. However, another mask such as a half tone mask may be used as the tone exposure method. The monitor lens 222 and the lens 212 are not necessarily manufactured by the tone exposure method, and may be manufactured using, for example, a reflow method or an etch back method.

First, up to formation of the underlayer 309 shown in Figs. 3B and 5, a known semiconductor process can be used for the formation. After the underlayer 309 is formed, a lens material layer (photosensitive material layer) using a photosensitive organic material is formed on the underlayer 309 over the pixel region 104 and the peripheral region 103. For example, a photosensitive resin is coated as the lens material layer using a spin coating method. Here, it is also possible to omit the underlayer 309 and planarize the upper surface of the color filter layer 308 using the lens material layer. In this case, it can be said that, in place of the underlayer 309, the color filter layer 308 is used as the underlayer on which the lens 212 and the monitor lens 222 are arranged.

After the lens material layer is formed, an arbitrary portion of the lens material layer is exposed, developed, and baked using the area tone mask with respect to the lens material layer. With the process described above, the lens 212 is formed in the pixel region 104, and the monitor lens 222 is formed in the monitor region 106. After the lens 222 and the monitor lens 222 are formed, the monitor lens 222 formed in the monitor region 106 is measured using an AFM or the like, and thus the shape and height of the lens 212 are monitored. If the shape of the monitor lens 222 including the height H3 has a desired value, the process of manufacturing the semiconductor device 101 advances to the next processing (process). On the other hand, if the shape of the monitor lens 222 including the height H3 does not have the desired value, the lens 212 and the monitor lens 222 may be removed from the substrate 100 (structure 301). In this case, the lens 212 and the monitor lens 222 are formed again (rework), and the shape of the monitor lens 222 can be measured again.

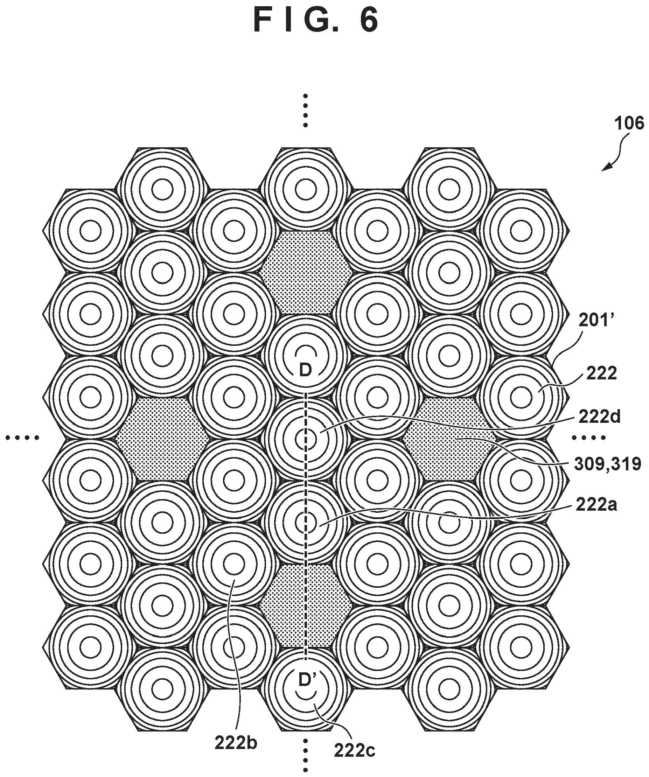

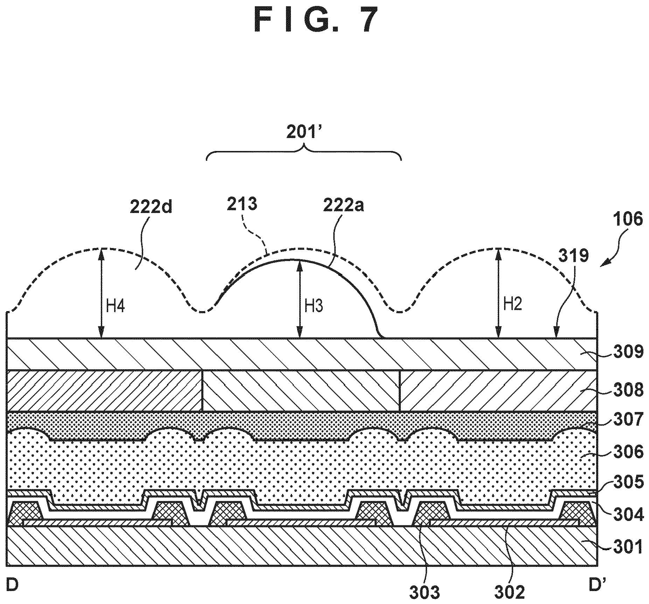

Figs. 6 and 7 are a plan view and a sectional view, respectively, showing a modification of the monitor region 106 of the semiconductor device 101 shown in Figs. 4 and 5 described above. Fig. 6 shows a part of the monitor region 106, and Fig. 7 is a sectional view taken along a line D - D' shown in Fig. 6.

Also in the arrangement shown in Figs. 6 and 7, the plurality of monitor lenses 222 include a pair of monitor lenses (for example, a pair of the monitor lens 222a and the monitor lens 222b) arranged such that the underlayer 309 is not exposed between two monitor lenses 222 adjacent to each other, and a pair of monitor lenses (for example, the monitor lens 222a and the monitor lens 222c) arranged with the exposed portion 319 where the underlayer 309 is exposed between two monitor lenses 222 adjacent to each other. Further, in the arrangement shown in Figs. 6 and 7, in addition to the arrangement described using Figs. 4 and 5, the plurality of monitor lenses 222 include a monitor lens 222d which is not in contact with the exposed portion 319.

Also in the arrangement shown in Figs. 6 and 7, as has been described above, the mask pattern for forming the monitor lens 222 can be formed using a mask pattern similar to the mask pattern for forming the plurality of lenses 212 arranged in the pixel region 104. That is, the arranging interval of two monitor lenses, among the plurality of monitor lenses 222, adjacent to each other arranged such that the underlayer 309 is not exposed (for example, the interval between the monitor lens 222a and the monitor lens 222b) can be equal to the arranging pitch of the plurality of lenses 212 arranged in the pixel region 104. Thus, Fig. 7 shows the outline of the lenses 212 arranged in the pixel region 104 by using a dashed line 213. As indicated by the dashed line 213, the height of the lens 212 is the height H2.

For example, even if the same mask pattern as the lens 212 is used during exposure, the monitor lens 222a in contact with the exposed portion 319 may not have the same shape as the lens 212 due to the influence of the exposed portion 319 in contact. As has been described above, the influence of arranging the exposed portion 319 can include the optical influence of exposure light from the exposed portion 319 during exposure of the monitor lens 222, the influence of the difference in stress between the adjacent lenses caused by nonuniformity in the shape of the monitor lens 222, and the like. Accordingly, for example, the height of the monitor lens 222a may be smaller than that of the lens 212. That is, as shown in Fig. 7, the relationship between the height H3 of the monitor lens 222a and the height H2 of the lens 212 may be expressed as H3 < H2.

On the other hand, the monitor lens 222d is not in contact with the exposed portion 319, and formed at a position away from the exposed portion 319 by a certain distance. In addition, the entire circumference of the monitor lens 222d is in contact with other monitor lenses 222. Hence, like the lenses 212 arranged in the two-dimensional array, the monitor lens 222d is continuous from the monitor lenses 222. Therefore, as compared to the monitor lens 222a, the monitor lens 222d is less likely to be influenced by the exposed portion 319, and can be formed to have a shape more similar to the shape of the lens 212 than the monitor lens 222a. As a result, the relationship among the height H3 of the monitor lens 222a, a height H4 of the monitor lens 222d, and the height H2 of the lens 212 can be expressed as H3 < H4 < H2. Further, for example, H4 ≈ H2 can hold.

As has been described above, when measuring the shape of the monitor lens 222, the monitor lens 222d not in contact with the exposed portion 319 is set as the measurement target. With this, the monitor lens 222 having a shape more similar to the shape of the lens 212 formed in the pixel region 104 is monitored. As a result, the process control of the surface shape of the lens 212 can be performed with higher accuracy.

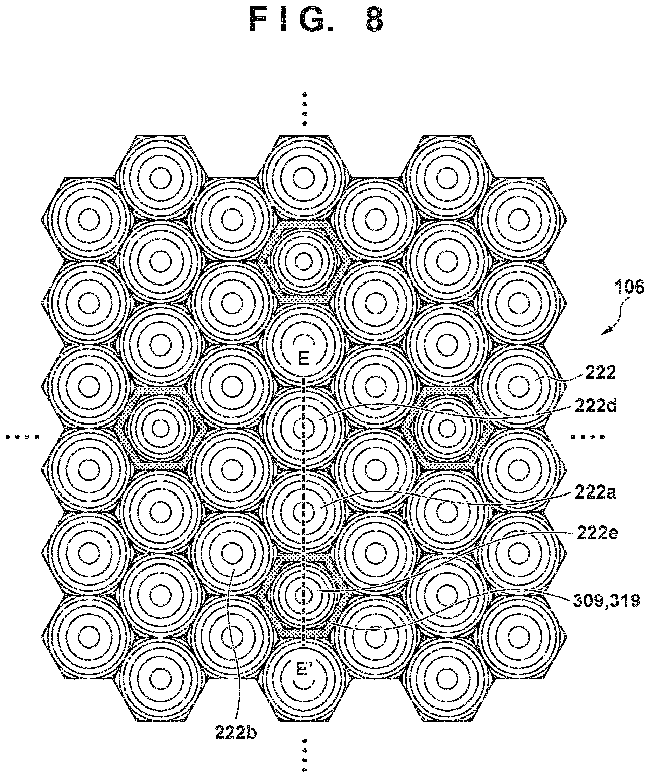

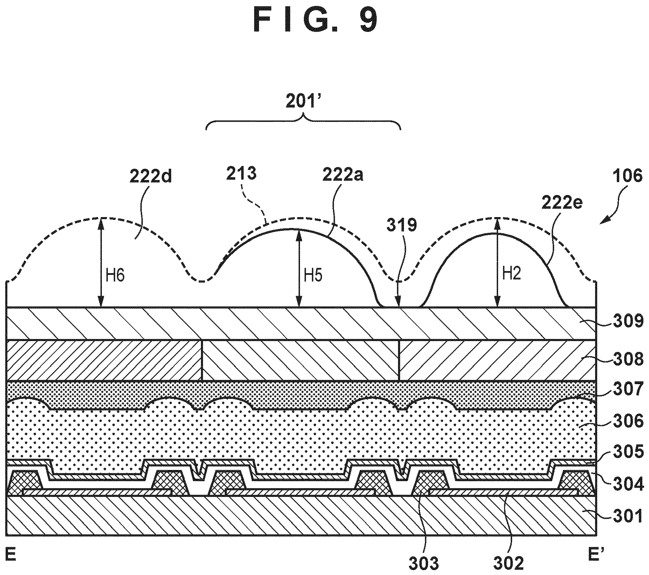

Figs. 8 and 9 are a plan view and a sectional view, respectively, showing a modification of the monitor region 106 of the semiconductor device 101 shown in Figs. 6 and 7 described above. Fig. 8 shows a part of the monitor region 106, and Fig. 9 is a sectional view taken along a line E - E' shown in Fig. 8.

In the arrangement shown in Figs. 8 and 9, the plurality of monitor lenses 222 include a pair of monitor lenses (for example, a pair of the monitor lens 222a and the monitor lens 222b) arranged such that the underlayer 309 is not exposed between two monitor lenses 222 adjacent to each other, and a pair of monitor lenses (for example, the monitor lens 222a and a monitor lens 222e) arranged with the exposed portion 319 where the underlayer 309 is exposed between two monitor lenses 222 adjacent to each other. The plurality of monitor lenses 222 also include the monitor lens 222d not in contact with the exposed portion 319.

Here, in the arrangements shown in Figs. 4 to 7 described above, the arranging interval of two monitor lenses, among the plurality of monitor lenses 222, adjacent to each other via the exposed portion 319 (for example, the interval between the monitor lens 222a and the monitor lens 222c) is larger than the arranging pitch of the plurality of lenses 212 arranged in the pixel region 104. It can also be said that the arrangement of the monitor lenses 222 in the monitor region 106 corresponds to the arrangement in which some of the plurality of lenses 212 arranged at a predetermined pitch in the pixel region 104 are not formed. On the other hand, in the arrangement shown in Figs. 8 and 9, the arranging interval of two monitor lenses, among the plurality of monitor lenses 222, adjacent to each other via the exposed portion 319 (for example, the interval between the monitor lens 222a and the monitor lens 222e) can be equal to the arranging pitch of the plurality of lenses 212 arranged in the pixel region 104.

More specifically, two monitor lenses, among the plurality of monitor lenses 222, adjacent to each other via the exposed portion 319 include the monitor lenses 222a and 222d which are in contact with some monitor lenses of the plurality of monitor lenses 222, and the monitor lens 222e which is not in contact with any other monitor lenses of the plurality of monitor lenses 222. In this case, in the planar view, the diameter of the monitor lens 222e is smaller than the diameter of each of two monitor lenses (for example, the monitor lenses 222a and 222d), among the plurality of monitor lenses 222, adjacent to each other arranged such that the underlayer 309 is not exposed. With this arrangement, the exposed portion 319 where the underlayer 309 is exposed can be arranged in the monitor region 106, and the reference point for the height in AFM measurement can be set. The monitor lens 222e can be formed using a mask pattern different from the mask pattern for the monitor lenses 222 other than the monitor lens 222e. Here, in the planar view, the diameter of the monitor lens 222e can be defined by the length of a line passing through the top of the monitor lens 222e and connecting points on the outer edge thereof. In addition, the diameter of each of two monitor lenses (for example, the monitor lenses 222a and 222d) adjacent to each other arranged such that the underlayer 309 is not exposed can be defined as the interval at which the monitor lens 222a and the monitor lens 222d are arranged. This is because the length 1/2 the arranging interval of the monitor lens 222a and the monitor lens 222d can correspond to the radius of each of the monitor lenses 222a and 222d.

Fig. 9 shows the outline of the lenses 212 arranged in the pixel region 104 by using the dashed line 213 as in Fig. 7. As indicated by the dashed line 213, the height of the lens 212 is the height H2.

Since the monitor lens 222a is in contact with the exposed portion 319, it can have a shape different from the shape of the lens 212 due to the influence of the exposed portion 319 as has been described above. However, as compared to the arrangement shown in Fig. 7, the exposed portion 319 is small, and there is the monitor lens 222e in a part of the portion where the exposed portion 319 is arranged in Fig. 7. With this, the influence of the exposed portion 319 on the monitor lens 222a decreases, and the monitor lens 222a shown in Fig. 9 can have a shape more similar to the shape of the lens 212 than the monitor lens 222a shown in Fig. 7. Letting H5 be the height of the monitor lens 222a shown in Fig. 9, the relationship with the height H3 of the monitor lens 222a shown in Fig. 7 and the height H2 of the lens 212 can be expressed as H3 < H5 < H2.

In addition, as in the above description, the monitor lens 222d is not in contact with the exposed portion 319, so that the influence of the exposed portion 319 further decreases. Accordingly, as compared to the arrangement shown in Fig. 7, the monitor lens 222d is less influenced by the exposed portion 319, so that it can be formed to have a shape similar to the shape of the lens 212. When the height of the monitor lens 222d in the arrangement shown in Figs. 8 and 9 is a height H6, the relationship among the height H6 and the height H4 of the monitor lens 222d and the height H2 of the lens 212 shown in Figs. 6 and 7 can be expressed as H4 < H6 < H2. Further, for example, H4 < H6 ≈ H2 can hold.

In this manner, in the monitor region 106, the plurality of monitor lenses 222 are arranged at the same pitch as the arranging pitch of the plurality of lenses 212 arranged in the pixel region 104. In this case, the exposed portions 319, where the underlayer 309 is exposed, are provided by forming some monitor lenses 222 smaller than the other monitor lenses 222. With this, the monitor lens 222 having a shape more similar to the shape of the lens 212 formed in the pixel region 104 is monitored. As a result, the process control of the surface shape of the lens 212 can be performed with higher accuracy.

In Figs. 8 and 9, an example is shown in which a lens shape similar to the other monitor lenses 222 is formed as the monitor lens 222e by using a tone exposure method or the like. However, the present invention is not limited to this. For example, after the lens material layer is formed, the mask in the portion where the monitor lens 222e is to be formed may not have tone. In this case, for example, the monitor lens 222e can be arranged not as a lens-shaped resin layer but as a mesa-shaped resin layer in the monitor region 106 of the semiconductor device 101. As compared to the top of the lens shape, since the mesa-shaped monitor lens 222e does not undergo tone exposure, for example, the height of the mesa-shaped monitor lens 222e from the underlayer 309 may be larger than that of each of the monitor lenses 222a and 222d formed into the lens shape. Further, for example, the top of the mesa-shaped monitor lens 222e may be flatter than the top of each of the monitor lenses 222a and 222d formed into the lens shape. Furthermore, for example, the mesa-shaped or lens-shaped monitor lens 222e may be used for monitoring the shape of the lens 212. As in the above description, by acquiring the correlation between the shape of the lens 212 and the shape of the monitor lens 222e in advance during trial production or the like, it is possible to use the monitor lens 222e for monitoring the shape of the lens 212. Since the mesa-shaped monitor lens 222e is likely to have a flat top, the height of the mesa-shaped monitor lens 222e from the exposed portion 319 can be measured more accurately and easily than the lens-shaped monitor lens 222 which can have a point-like top (vertex). Alternatively, for example, a mesa-shaped resin layer, which is not in contact with the plurality of monitor lenses 222 and has a flat top, may be arranged in the monitor region 106 separately from the monitor lens 222. In the planar view, the mesa-shaped resin layer can be surrounded by the exposed portion 319. As in the case in which the monitor lens 222e is formed into a mesa shape, the height of the mesa-shaped resin layer from the underlayer 309 may be larger than that of the monitor lens 222 formed into the lens shape. In the planar view, the mesa-shaped resin layer may be larger than each monitor lens 222. In the monitor region 106, only one mesa-shaped resin layer may be arranged, or a plurality of mesa-shaped resin layers may be arranged. In the above description, the plurality of monitor lenses 222 are patterned from the lens material layer in the monitor region 106. However, for example, when forming the monitor region 106, without patterning respective monitor lenses 222, integrated mesa-shaped resin layers may be formed from the lens material layer in the monitor region 106. Even in this case, the exposed portion 319 where the underlayer 309 is exposed is arranged in a part of the monitor region 106. As in the above description, by acquiring the correlation between the shape of the lens 212 and the shape of the mesa-shaped resin layer in advance during trial production or the like, it is possible to use the mesa-shaped resin layer for monitoring the shape of the lens 212.

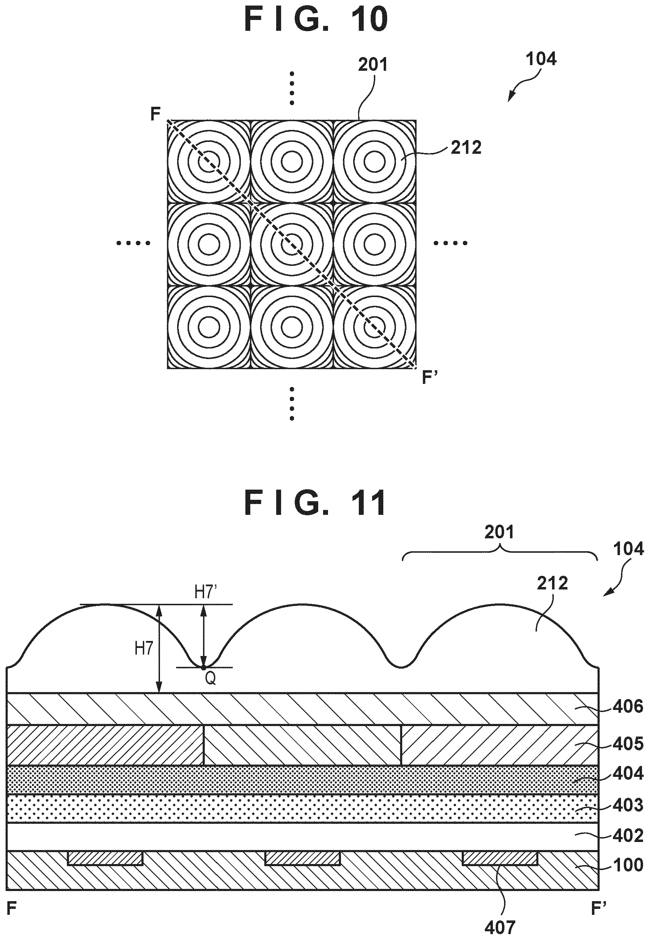

In each embodiment described above, it has been described that the pixel 201 arranged in the pixel region 104 of the semiconductor device 101 includes the light emitting element. However, as has been described above, the plurality of pixels 201 arranged in the pixel region 104 may each include the photoelectric conversion element. The arrangements in this case will be described with reference to Figs. 10 to 13. A description of the arrangement that may be similar to each arrangement described above will be omitted, as appropriate.

Figs. 10 and 11 are a plan view and a sectional view, respectively, for explaining the pixel 201 including the photoelectric conversion element arranged in the pixel region 104 of the semiconductor device 101 according to this embodiment. Fig. 10 shows the planar structure of the lenses 212 of this embodiment in which no gap exists between two lenses 212 adjacent to each other. More specifically, Fig. 10 shows a part of the pixel region 104, and the plurality of pixels 201 are arranged at a predetermined pitch in a two-dimensional array in the pixel region 104. Further, the plurality of lenses 212 are arranged at a predetermined pitch on an underlayer 406 such that the underlayer 406 is not exposed and one lens 212 corresponds to one pixel 201. Each lens 212 is in contact with the adjacent lens 212. In the planar view, there is no region where the underlayer 406 under the lens is exposed in the spacing between the lenses 212. In the arrangement shown in Fig. 10, the pixel 201 has a rectangular shape in the planar view, but the present invention is not limited to this. The pixel 201 may have, for example, a polygonal shape such as a hexagon.

Fig. 11 is a sectional view taken along a line F - F' shown in Fig. 10. In the arrangement shown in Fig. 11, the pixel 201 arranged in the pixel region 104 can include the substrate 100, a structure 402, a protection layer 403, a planarizing layer 404, a color filter layer 405, and the underlayer 406. The lens 212 is provided on the underlayer 406.

A photoelectric conversion element 407 is arranged in the substrate 100 in the pixel region 104. The photoelectric conversion element 407 generates a signal corresponding to the amount of light entering the photoelectric conversion element 407.

The structure 402 is arranged on the substrate 100. The structure 402 can include an insulating layer, a wiring pattern layer, and a conductor such as a contact plug. The structure 402 can include, for example, an insulating film containing silicon oxide or the like, and a wiring pattern containing copper, aluminum, or the like as a main component. The wiring pattern layer may include a plurality of layers stacked on each other.

The protection layer 403 is arranged on the structure 402. The protection layer 403 is arranged to suppress diffusion, to the structure 402 and the substrate 100, of water from the outside of the semiconductor device 101 and impurities from the color filter layer 405 and the like. For example, a silicon nitride or the like is used for the protection layer 403.

The planarizing layer 404 is arranged on the protection layer 403. The planarizing layer 404 is a layer for planarizing unevenness of the upper surface of the protection layer 403. For example, an organic material can be used for the planarizing layer 404, like the planarizing layer 307 described above. For example, a resin that can be spin-coated may be used for the planarizing layer 404. If unevenness of the upper surface of the protection layer 403 is not large, or if unevenness of the upper surface of the protection layer 403 can be planarized using a polishing process or the like, the planarizing layer 404 may not be provided.

The color filter layer 405 is arranged on the planarizing layer 404. The color filter layer 405 may include a plurality of kinds of filters each of which transmits (or absorbs) light of a specific frequency band. For example, the color filter layer 405 may be arranged such that one filter corresponds to each pixel 201 in the pixel region 104. The main configuration of the color filter layer 405 can be similar to that of the color filter layer 308.

The lens 202 is arranged on the color filter layer 405 via the underlayer 406. The underlayer 406 can be a planarizing layer for planarizing the surface of the layer (for example, the upper surface of the color filter layer 405) below the underlayer 406. A material similar to that of the planarizing layer 404 may be used for the underlayer 406. If unevenness of the upper surface of the color filter layer 405 is not large, the underlayer 406 may not be provided. In this case, the color filter layer 405 can function as the underlayer of the lens 212.

In the lens 212, the upper surface of the underlayer 406 is set as a reference point, and the difference between the height of the reference point and the height of the top of the lens 212 is defined as a height H7 of the lens 212. In process control of the shape of the lens 212, as in the above description, the surface of the lens 212 is scanned using an AFM to measure unevenness of the lens 212. In this case, also in the case shown in Fig. 11, since the underlayer 406 is not exposed in the surface to be measured, the upper surface of the underlayer 406 cannot be used as the reference point. If a point Q indicating the valley portion between the lenses 212 adjacent to each other is set as the reference point for the height upon measuring the lens 212, the difference between the height of the point Q and the height of the top of the lens 212 is indicated by H7' as shown in Fig. 11. In this case, H7 ≠ H7', so that a value different from the actual height H7 of the lens 212 is measured.

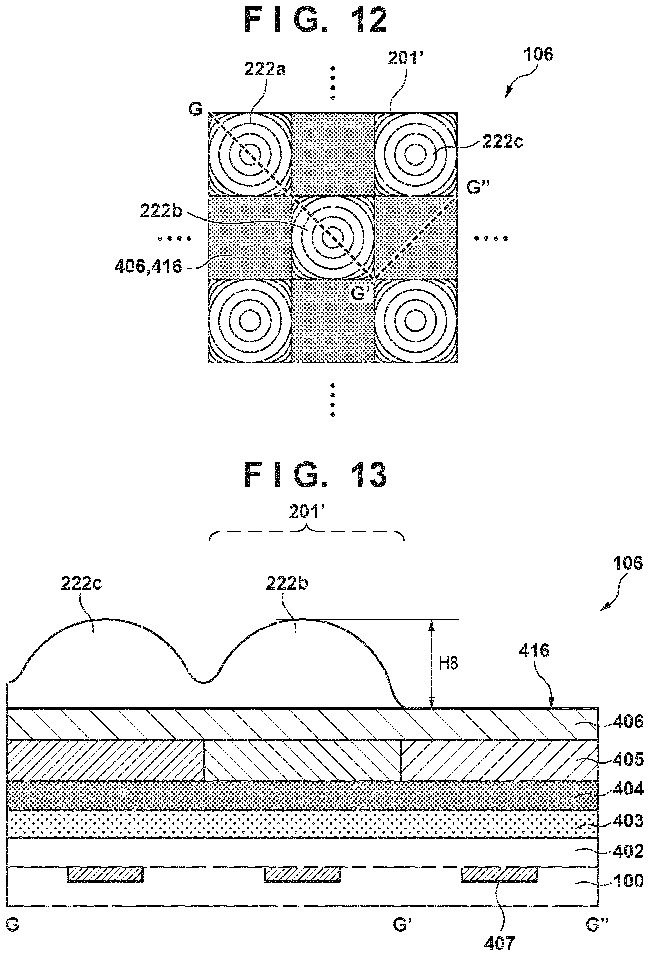

To avoid this, as in each embodiment described above, process control of the shape of the lens 212 is performed by providing the monitor region 106 in the peripheral region 103 of the semiconductor device 101, and monitoring the shape of the monitor lens 222. Figs. 12 and 13 are a plan view and a sectional view, respectively, for explaining the monitor lens 222 arranged in the monitor region 106 of the semiconductor device 101 according to this embodiment. Fig. 12 shows a part of the monitor region 106, and Fig. 13 is a sectional view taken along a line G - G' - G" shown in Fig. 12.

In the monitor region 106, the plurality of monitor lenses 222 are arranged on the underlayer 406. The plurality of monitor lenses 222 include a pair of monitor lenses (for example, a pair of the monitor lens 222a and the monitor lens 222b) arranged such that the underlayer 406 is not exposed between two monitor lenses 222 adjacent to each other, and a pair of monitor lenses (for example, the monitor lens 222a and the monitor lens 222c) arranged with an exposed portion 416 where the underlayer 406 is exposed between two monitor lenses 222 adjacent to each other. That is, in the planar view, the plurality of monitor lenses 222 and a plurality of the exposed portions 416 are two-dimensionally arrayed in the monitor region 106. Further, parts of the underlayer 406 under the monitor lenses 222 are exposed in the monitor region 106.

In this embodiment, in process control of the shape of the lens 212, the height of the monitor lens 222 can be measured. The shape of the monitor lens 222 can be measured by, for example, scanning unevenness of the surface including the monitor lens 222 and the exposed portion 416 in the monitor region 106 by using an AFM. In this case, unlike the lens 212 in the pixel region 104, since the exposed portion 416 is provided, the exposed portion 416 can be used as the reference point for the height in the AFM measurement. The difference between the height of the reference point and the height of the top of the monitor lens 222 is a height H8 of the monitor lens 222 as shown in Fig. 13, so that the height of the monitor lens 222 can be accurately measured.

In this manner, even in a case in which the photoelectric conversion element 407 is arranged in the pixel 201 arranged in the pixel region 104 of the semiconductor device 101, it is possible to perform process control of the surface shape of the lens 212 with high accuracy. Further, even in the case in which the photoelectric conversion element 407 is arranged in the pixel 201, the lens 212 and the monitor lens 222 can be formed as in the case in which the light emitting element is arranged in the pixel 201.

In the arrangement shown in Figs. 12 and 13, the arrangement from the structure 301 to the underlayer 309 shown in Figs. 4 and 5 described above is replaced with the arrangement from the substrate 100 to the underlayer 406. However, the present invention is not limited to this, and the arrangement and shape of the monitor lens 222 shown in Figs. 6 to 9 may be combined with the arrangement from the substrate 100 to the underlayer 406 shown in Figs. 10 to 13.

That is, in a case in which the lens 212 is arranged in the pixel region 104 of the semiconductor device 101, by arranging the monitor lens 222 described above, it is possible to perform process control of the shape of the lens 212 with high accuracy regardless of the configuration of the pixel 201. Thus, in the semiconductor device 101 in which the light emitting element is arranged in the pixel region 104, for example, high resolution of a displayed image is implemented. Similarly, in the semiconductor device 101 in which the photoelectric conversion element is arranged in the pixel region 104, for example, high resolution of an image obtained by image capturing is implemented.

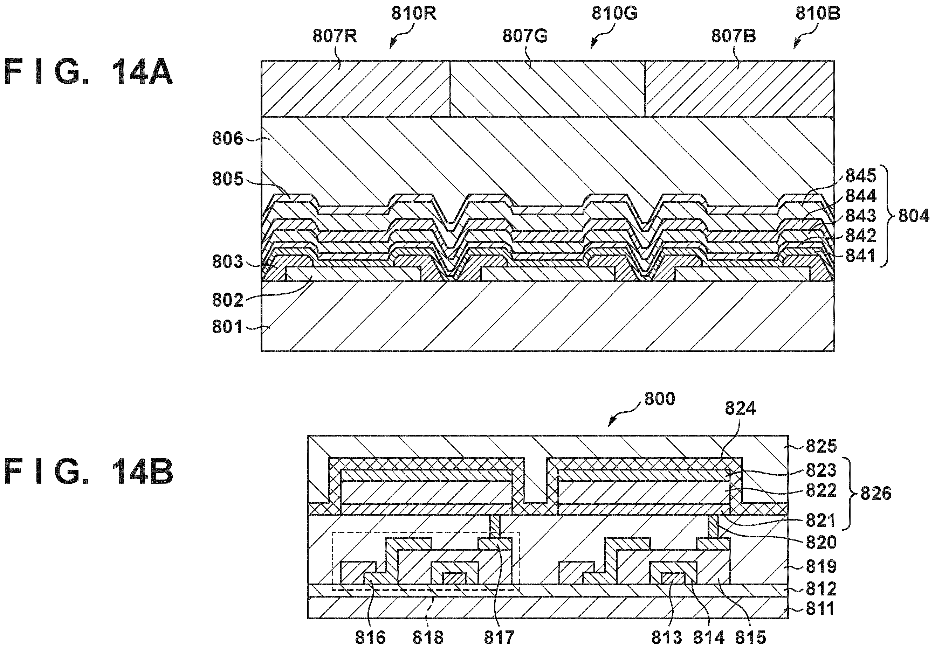

Here, application examples in which the semiconductor device 101 according to this embodiment, which functions as a light emitting device and in which the pixel 201 arranged in the pixel region 104 includes the light emitting element as has been described above, is applied to an image forming device, a display device, a photoelectric conversion device, an electronic apparatus, an illumination device, a moving body, and a wearable device will be described here with reference to Figs. 14A to 22B. The description will be given assuming that a light emitting element, for example, an organic light emitting element such as an organic EL element is arranged in the pixel 201 arranged in the pixel region 104 of the semiconductor device 101 as has been described above. Details of each component arranged in the pixel region 104 of the semiconductor device 101 described above will be described first, and the application examples will be described after that.

### Arrangement of Organic Light Emitting Element

The organic light emitting element is provided by forming an insulating layer, a first electrode, an organic compound layer, and a second electrode on a substrate. A protection layer, a color filter, a microlens, and the like may be provided on a cathode. If a color filter is provided, a planarizing layer may be provided between the protection layer and the color filter. The planarizing layer can be formed using acrylic resin or the like. The same applies to a case in which a planarizing layer is provided between the color filter and the microlens.

### Substrate

Quartz, glass, a silicon wafer, a resin, a metal, or the like may be used as a substrate (corresponding to the substrate 100 described above). Furthermore, a switching element such as a transistor, a wiring pattern, and the like may be provided on the substrate, and an insulating layer may be provided thereon. The insulating layer may be made of any material as long as a contact hole can be formed so that the wiring pattern can be formed between the first electrode and the substrate and insulation from the unconnected wiring pattern can be ensured. For example, a resin such as polyimide, silicon oxide, silicon nitride, or the like may be used for the insulating layer.

### Electrode

A pair of electrodes (corresponding to the lower electrode 302 and the upper electrode 305 described above) can be used as the electrodes. The pair of electrodes can be an anode and a cathode. If an electric field is applied in the direction in which the organic light emitting element emits light, the electrode having a high potential is the anode, and the other is the cathode. It can also be said that the electrode that supplies holes to the light emitting layer is the anode and the electrode that supplies electrons is the cathode.

As the constituent material of the anode, a material having a large work function may be selected. For example, a metal such as gold, platinum, silver, copper, nickel, palladium, cobalt, selenium, vanadium, or tungsten, a mixture containing some of them, an alloy obtained by combining some of them, or a metal oxide such as tin oxide, zinc oxide, indium oxide, indium tin oxide (ITO), or zinc indium oxide can be used. Furthermore, a conductive polymer such as polyaniline, polypyrrole, or polythiophene can also be used as the constituent material of the anode.

One of these electrode materials may be used singly, or two or more of them may be used in combination. The anode may be formed by a single layer or a plurality of layers.

If the electrode is used as a reflective electrode, for example, chromium, aluminum, silver, titanium, tungsten, molybdenum, an alloy thereof, a stacked layer thereof, or the like can be used. The above materials can function as a reflective film having no role as an electrode. If a transparent electrode is used as the electrode, an oxide transparent conductive layer made of indium tin oxide (ITO), indium zinc oxide, or the like can be used, but the present invention is not limited thereto. A photolithography technique can be used to form the electrode.

On the other hand, as the constituent material of the cathode, a material having a small work function may be selected. Examples of the material include an alkali metal such as lithium, an alkaline earth metal such as calcium, a metal such as aluminum, titanium, manganese, silver, lead, or chromium, and a mixture containing some of them. Alternatively, an alloy obtained by combining these metals can also be used. For example, a magnesium-silver alloy, an aluminum-lithium alloy, an aluminum-magnesium alloy, a silver-copper alloy, a zinc-silver alloy, or the like can be used. A metal oxide such as indium tin oxide (ITO) can also be used. One of these electrode materials may be used singly, or two or more of them may be used in combination. The cathode may have a single-layer structure or a multilayer structure. Silver may be used as the cathode. To suppress aggregation of silver, a silver alloy may be used. The ratio of the alloy is not limited as long as aggregation of silver can be suppressed. For example, the ratio between silver and another metal may be 1 : 1, 3 : 1, or the like.

The cathode may be a top emission element using an oxide conductive layer made of ITO or the like, or may be a bottom emission element using a reflective electrode made of aluminum (Al) or the like, and is not particularly limited. The method of forming the cathode is not particularly limited, but if direct current sputtering or alternating current sputtering is used, the good coverage is achieved for the film to be formed, and the resistance of the cathode can be lowered.

### Pixel Separation Layer

A pixel separation layer (corresponding to the insulating layer 303 described above) may be formed by a so-called silicon oxide, such as silicon nitride (SiN), silicon oxynitride (SiON), or silicon oxide (SiO), formed using a Chemical Vapor Deposition (CVD) method. To increase the resistance in the in-plane direction of the organic compound layer, the organic compound layer, especially the hole transport layer may be thinly deposited on the side wall of the pixel separation layer. More specifically, the organic compound layer can be deposited so as to have a thin film thickness on the side wall by increasing the taper angle of the side wall of the pixel separation layer or the film thickness of the pixel separation layer to increase vignetting during vapor deposition.

On the other hand, the taper angle of the side wall of the pixel separation layer or the film thickness of the pixel separation layer can be adjusted to the extent that no space is formed in the protection layer formed on the pixel separation layer. Since no space is formed in the protection layer, it is possible to reduce generation of defects in the protection layer. Since generation of detects in the protection layer is reduced, a decrease in reliability caused by generation of a dark spot or occurrence of a conductive failure of the second electrode can be reduced.

According to this embodiment, even if the taper angle of the side wall of the pixel separation layer is not acute, it is possible to effectively suppress leakage of charges to an adjacent pixel. As a result of this consideration, it has been found that the taper angle of 60° (inclusive) to 90° (inclusive) can sufficiently reduce the occurrence of defects. The film thickness of the pixel separation layer may be 10 nm (inclusive) to 150 nm (inclusive). A similar effect can be obtained in an arrangement including only pixel electrodes without the pixel separation layer. However, in this case, the film thickness of the pixel electrode is set to be equal to or smaller than half the film thickness of the organic layer or the end portion of the pixel electrode is formed to have a forward tapered shape of less than 60°. With this, short circuit of the organic light emitting element can be reduced.

Furthermore, in a case where the first electrode is the cathode and the second electrode is the anode, a high color gamut and low-voltage driving can be achieved by forming the electron transport material and charge transport layer and forming the light emitting layer on the charge transport layer.

### Organic Compound Layer

The organic compound layer (corresponding to the organic layer 304 described above) may be formed by a single layer or a plurality of layers. If the organic compound layer includes a plurality of layers, the layers can be called a hole injection layer, a hole transport layer, an electron blocking layer, a light emitting layer, a hole blocking layer, an electron transport layer, and an electron injection layer in accordance with the functions of the layers. The organic compound layer is mainly formed from an organic compound but may contain inorganic atoms and an inorganic compound. For example, the organic compound layer may contain copper, lithium, magnesium, aluminum, iridium, platinum, molybdenum, zinc, or the like. The organic compound layer may be arranged between the first and second electrodes, and may be arranged in contact with the first and second electrodes.

### Protection Layer

A protection layer (corresponding to the protection layer 306 described above) may be provided on the cathode. For example, by adhering glass provided with a moisture absorbing agent on the cathode, permeation of water or the like into the organic compound layer can be suppressed and occurrence of display defects can be suppressed. Furthermore, as another embodiment, a passivation layer made of silicon nitride or the like may be provided on the cathode to suppress permeation of water or the like into the organic compound layer. For example, the protection layer can be formed by forming the cathode, transferring it to another chamber without breaking the vacuum, and forming silicon nitride having a thickness of 2 µm by the CVD method. The protection layer may be provided using an atomic layer deposition (ALD) method after deposition of the protection layer using the CVD method. The material of the protection layer by the ALD method is not limited but can be silicon nitride, silicon oxide, aluminum oxide, or the like. Silicon nitride may further be formed by the CVD method on the protection layer formed by the ALD method. The protection layer formed by the ALD method may have a film thickness smaller than that of the protection layer formed by the CVD method. More specifically, the film thickness of the protection layer formed by the ALD method may be 50% or less, or 10% or less of that of the protection layer formed by the CVD method.

### Color Filter

A color filter (corresponding to the color filter layer 308 described above) may be provided on the protection layer. For example, a color filter considering the size of the organic light emitting element may be provided on another substrate, and the substrate with the color filter formed thereon may be bonded to the substrate with the organic light emitting element provided thereon. Alternatively, for example, a color filter may be patterned on the above-described protection layer using a photolithography technique. The color filter may be formed from a polymeric material.

### Planarizing Layer

A planarizing layer (corresponding to the planarizing layer 307 described above) may be arranged between the color filter and the protection layer. The planarizing layer is provided to reduce unevenness of the layer below the planarizing layer. The planarizing layer may be called a material resin layer without limiting the purpose of the layer. The planarizing layer may be formed from an organic compound, and may be made of a low-molecular material or a polymeric material. In consideration of reduction of unevenness, a polymeric organic compound may be used for the planarizing layer.

The planarizing layers may be provided above and below the color filter (the planarizing layer provided on the color filter corresponds to the underlayer 309 described above). In that case, the same or different constituent materials may be used for these planarizing layers. More specifically, examples of the material of the planarizing layer include polyvinyl carbazole resin, polycarbonate resin, polyester resin, ABS resin, acrylic resin, polyimide resin, phenol resin, epoxy resin, silicone resin, and urea resin.

### Microlens

The organic light emitting device may include an optical member such as a microlens (corresponding to the lens 202 or 212 described above) on the light emission side. The microlens can be made of acrylic resin, epoxy resin, or the like. For the microlens, objectives are to increase the amount of light extracted from the organic light emitting device and control the direction of light to be extracted. The microlens can have a hemispherical shape. If the microlens has a hemispherical shape, among tangents contacting the hemisphere, there is a tangent parallel to the insulating layer, and the contact between the tangent and the hemisphere is the vertex of the microlens. The vertex of the microlens can be decided in the same manner even in an arbitrary sectional view. That is, among tangents contacting the semicircle of the microlens in a sectional view, there is a tangent parallel to the insulating layer, and the contact between the tangent and the semicircle is the vertex of the microlens.

Furthermore, the middle point of the microlens can also be defined. In the section of the microlens, a line segment from a point at which an arc shape ends to a point at which another arc shape ends is assumed, and the middle point of the line segment can be called the middle point of the microlens. A section for determining the vertex and the middle point may be a section perpendicular to the insulating layer.

The microlens includes a first surface including a convex portion and a second surface opposite to the first surface. The second surface can be arranged on the functional layer (light emitting layer) side of the first surface. For this arrangement, the microlens needs to be formed on the light emitting device. If the functional layer is an organic layer, a process which produces high temperature in the manufacturing step of the microlens may be avoided. In addition, if it is configured to arrange the second surface on the functional layer side of the first surface, all the glass transition temperatures of an organic compound forming the organic layer may be 100°C or more. For example, 130°C or more is suitable.

### Counter Substrate

A counter substrate may be arranged on the planarizing layer. The counter substrate is called a counter substrate because it is provided at a position corresponding to the above-described substrate. The constituent material of the counter substrate can be the same as that of the above-described substrate. If the above-described substrate is the first substrate, the counter substrate can be the second substrate.

### Organic Layer

The organic compound layer (hole injection layer, hole transport layer, electron blocking layer, light emitting layer, hole blocking layer, electron transport layer, electron injection layer, and the like) forming the organic light emitting element according to an embodiment of the present disclosure may be formed by the method to be described below.

The organic compound layer forming the organic light emitting element according to the embodiment of the present disclosure can be formed by a dry process using a vacuum deposition method, an ionization deposition method, a sputtering method, a plasma method, or the like. Instead of the dry process, a wet process that forms a layer by dissolving a solute in an appropriate solvent and using a well-known coating method (for example, a spin coating method, a dipping method, a casting method, a Langmuir-Blodgett (LB) method, an inkjet method, or the like) can be used.

Here, when the layer is formed by a vacuum deposition method, a solution coating method, or the like, crystallization or the like hardly occurs and excellent temporal stability is obtained. Furthermore, when the layer is formed using a coating method, it is possible to form the film in combination with a suitable binder resin.

Examples of the binder resin include polyvinyl carbazole resin, polycarbonate resin, polyester resin, ABS resin, acrylic resin, polyimide resin, phenol resin, epoxy resin, silicone resin, and urea resin. However, the binder resin is not limited to them.

One of these binder resins may be used singly as a homopolymer or a copolymer, or two or more of them may be used in combination. Furthermore, additives such as a well-known plasticizer, antioxidant, and an ultraviolet absorber may also be used as needed.

### Pixel Circuit

The light emitting device can include a pixel circuit connected to the light emitting element. The pixel circuit may be an active matrix circuit that individually controls light emission of the first and second light emitting elements. The active matrix circuit may be a voltage or current programing circuit. A driving circuit includes a pixel circuit for each pixel. The pixel circuit can include a light emitting element, a transistor for controlling light emission luminance of the light emitting element, a transistor for controlling a light emission timing, a capacitor for holding the gate voltage of the transistor for controlling the light emission luminance, and a transistor for connection to GND without intervention of the light emitting element.

The light emitting device includes a display region and a peripheral region arranged around the display region. The light emitting device includes the pixel circuit in the display region and a display control circuit in the peripheral region. The mobility of the transistor forming the pixel circuit may be smaller than that of a transistor forming the display control circuit.

The slope of the current-voltage characteristic of the transistor forming the pixel circuit may be smaller than that of the current-voltage characteristic of the transistor forming the display control circuit. The slope of the current-voltage characteristic can be measured by a so-called Vg-Ig characteristic.

The transistor forming the pixel circuit is a transistor connected to the light emitting element such as the first light emitting element.

### Pixel

The organic light emitting device includes a plurality of pixels. Each pixel includes sub-pixels (corresponding to the pixels 201 described above) that emit light components of different colors. The sub-pixels may include, for example, R, G, and B emission colors, respectively.

In each pixel, a region also called a pixel opening emits light. The pixel opening can have a size of 5 µm (inclusive) to 15 µm (inclusive). More specifically, the pixel opening can have a size of 11 µm, 9.5 µm, 7.4 µm, 6.4 µm, or the like.

A distance between the sub-pixels can be 10 µm or less, and can be, more specifically, 8 µm, 7.4 µm, or 6.4 µm.

The pixels can have a known arrangement form in a plan view. For example, the pixels may have a stripe arrangement, a delta arrangement, a pentile arrangement, or a Bayer arrangement. The shape of each sub-pixel in a plan view may be any known shape. For example, a quadrangle such as a rectangle or a rhombus, a hexagon, or the like may be possible. A shape which is not a correct shape but is close to a rectangle is included in a rectangle, as a matter of course. The shape of the sub-pixel and the pixel arrangement can be used in combination.

Application of Organic Light Emitting Element of Embodiment of Present Disclosure

The organic light emitting element according to an embodiment of the present disclosure can be used as a constituent member of a display device or an illumination device. In addition, the organic light emitting element is applicable to the exposure light source of an electrophotographic image forming device, the backlight of a liquid crystal display device, a light emitting device including a color filter in a white light source, and the like.

The display device may be an image information processing device that includes an image input unit for inputting image information from an area CCD, a linear CCD, a memory card, or the like, and an information processing unit for processing the input information, and displays the input image on a display unit.

In addition, a display unit included in an image capturing device or an inkjet printer can have a touch panel function. The driving type of the touch panel function may be an infrared type, a capacitance type, a resistive film type, or an electromagnetic induction type, and is not particularly limited. The display device may be used for the display unit of a multifunction printer.

More details will be described next with reference to the accompanying drawings. Fig. 14A shows an example of a pixel as a constituent element of the above-described pixel region 104. The pixel includes sub-pixels 810 (corresponding to the pixels 201 described above). The sub-pixels are divided into sub-pixels 810R, 810G, and 810B by emitted light components. The light emission colors may be discriminated by the wavelengths of light components emitted from the light emitting layers, or light emitted from each sub-pixel may be selectively transmitted or undergo color conversion by a color filter or the like. Each sub-pixel includes a reflective electrode 802 (corresponding to the lower electrode 302 described above) as the first electrode on an interlayer insulating layer 801 (corresponding to a part of the structure 301 described above), an insulating layer 803 (corresponding to the insulating layer 303 described above) covering the end of the reflective electrode 802, an organic compound layer 804 (corresponding to the organic layer 304 described above) covering the first electrode and the insulating layer, a transparent electrode 805 (corresponding to the upper electrode 305 described above) as the second electrode, a protection layer 806 (corresponding to the protection layer 306 and the planarizing layer 307 described above), and a color filter 807 (corresponding to the color filter layer 308 described above).

The interlayer insulating layer 801 can include a transistor and a capacitive element arranged in the interlayer insulating layer 801 or a layer below it. The transistor and the first electrode can electrically be connected via a contact hole (not shown) or the like.

The insulating layer 803 can also be called a bank or a pixel separation film. The insulating layer 803 covers the end of the first electrode, and is arranged to surround the first electrode. A portion of the first electrode where no insulating layer 803 is arranged is in contact with the organic compound layer 804 to form a light emitting region.

The organic compound layer 804 includes a hole injection layer 841, a hole transport layer 842, a first light emitting layer 843, a second light emitting layer 844, and an electron transport layer 845.

The second electrode may be a transparent electrode, a reflective electrode, or a semi-transmissive electrode.

The protection layer 806 suppresses permeation of water into the organic compound layer. The protection layer is shown as a single layer but may include a plurality of layers. Each layer can be an inorganic compound layer or an organic compound layer.

The color filter 807 is divided into color filters 807R, 807G, and 807B by colors. The color filters can be formed on a planarizing film (not shown). A resin protection layer (not shown) may be arranged on the color filters. The color filters can be formed on the protection layer 806. Alternatively, the color filters can be provided on the counter substrate such as a glass substrate, and then the substrate may be bonded.

A display device 800 (corresponding to the semiconductor device 101 described above) shown in Fig. 14B is provided with an organic light emitting element 826 and a TFT 818 as an example of a transistor. A substrate 811 of glass, silicon, or the like is provided and an insulating layer 812 is provided on the substrate 811. The active element such as the TFT 818 is arranged on the insulating layer, and a gate electrode 813, a gate insulating film 814, and a semiconductor layer 815 of the active element are arranged. The TFT 818 further includes the semiconductor layer 815, a drain electrode 816, and a source electrode 817. An insulating film 819 is provided on the TFT 818. The source electrode 817 and an anode 821 forming the organic light emitting element 826 are connected via a contact hole 820 formed in the insulating film.

A method of electrically connecting the electrodes (anode and cathode) included in the organic light emitting element 826 and the electrodes (source electrode and drain electrode) included in the TFT is not limited to that shown in Fig. 14B. That is, one of the anode and cathode and one of the source electrode and drain electrode of the TFT are electrically connected. The TFT indicates a thin-film transistor.

In the display device 800 shown in Fig. 14B, an organic compound layer is illustrated as one layer. However, an organic compound layer 822 may include a plurality of layers. A first protection layer 824 and a second protection layer 825 are provided on a cathode 823 to suppress deterioration of the organic light emitting element.

A transistor is used as a switching element in the display device 800 shown in Fig. 14B but may be used as another switching element.

The transistor used in the display device 800 shown in Fig. 14B is not limited to a transistor using a single-crystal silicon wafer, and may be a thin-film transistor including an active layer on an insulating surface of a substrate. Examples of the active layer include single-crystal silicon, amorphous silicon, non-single-crystal silicon such as microcrystalline silicon, and a non-single-crystal oxide semiconductor such as indium zinc oxide and indium gallium zinc oxide. Note that a thin-film transistor is also called a TFT element.

The transistor included in the display device 800 shown in Fig. 14B may be formed in the substrate such as a silicon substrate. Forming the transistor in the substrate means forming the transistor by processing the substrate such as a silicon substrate. That is, when the transistor is included in the substrate, it can be considered that the substrate and the transistor are formed integrally.

The light emission luminance of the organic light emitting element according to this embodiment can be controlled by the TFT which is an example of a switching element, and the plurality of organic light emitting elements can be provided in a plane to display an image with the light emission luminances of the respective elements. Here, the switching element according to this embodiment is not limited to the TFT, and may be a transistor formed from low-temperature polysilicon or an active matrix driver formed on the substrate such as a silicon substrate. The term "on the substrate" may mean "in the substrate". Whether to provide a transistor in the substrate or use a TFT is selected based on the size of the display unit. For example, if the size is about 0.5 inch, the organic light emitting element may be provided on the silicon substrate.

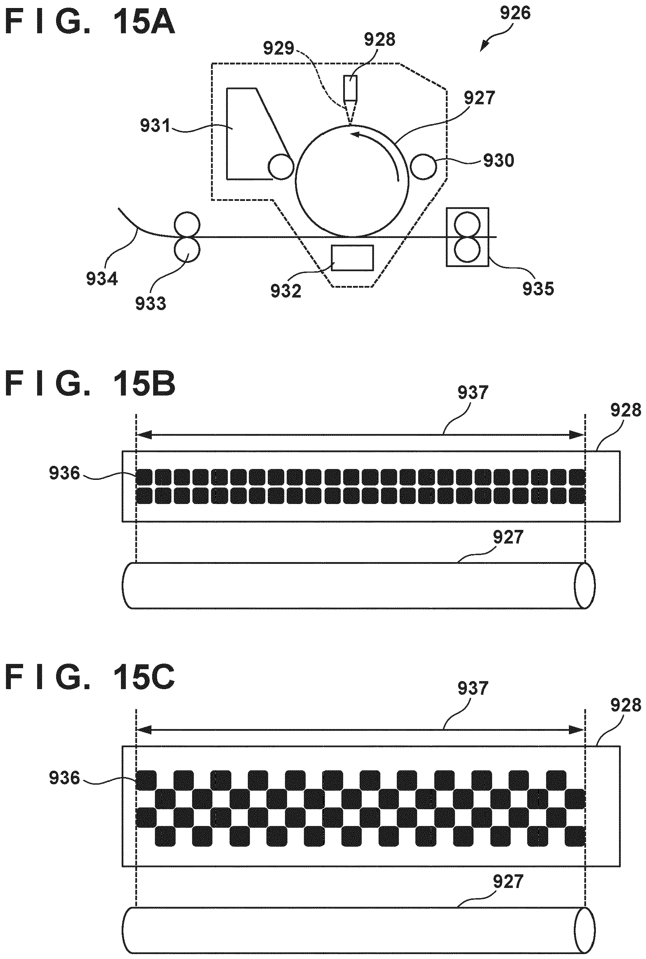

Figs. 15A to 15C are schematic views showing an example of an image forming device using the semiconductor device 101 according to this embodiment. An image forming device 926 shown in Fig. 15A includes a photosensitive member 927, an exposure light source 928, a developing unit 931, a charging unit 930, a transfer device 932, a conveyance unit 933 (a conveyance roller in the arrangement shown in Fig. 15A), and a fixing device 935.

Light 929 is emitted from the exposure light source 928, and an electrostatic latent image is formed on the surface of the photosensitive member 927. The semiconductor device 101 can be applied to the exposure light source 928. The developing unit 931 can function as a developing device that contains a toner or the like as a developing agent and applies the developing agent to the exposed photosensitive member 927. The charging unit 930 charges the photosensitive member 927. The transfer device 932 transfers the developed image to a print medium 934. The conveyance unit 933 conveys the print medium 934. The print medium 934 can be, for example, paper or a film. The fixing device 935 fixes the image formed on the print medium.

Each of Figs. 15B and 15C is a schematic view showing a plurality of light emitting units 936 arranged along the longitudinal direction on a long substrate in the exposure light source 928. The semiconductor device 101 can be applied to the light emitting units 936. That is, the plurality of pixels 201 arranged in the pixel region 104 are arranged along the longitudinal direction of the substrate. A direction 937 is a direction parallel to the axis of the photosensitive member 927. This column direction matches the direction of the axis upon rotating the photosensitive member 927. This direction 937 can be referred to as the long-axis direction of the photosensitive member 927.

Fig. 15B shows a form in which the light emitting units 936 are arranged along the long-axis direction of the photosensitive member 927. Fig. 15C shows a form, which is a modification of the arrangement of the light emitting units 936 shown in Fig. 15B, in which the light emitting units 936 are arranged in the column direction alternately between the first column and the second column. The light emitting units 936 are arranged at different positions in the row direction between the first column and the second column. In the first column, multiple light emitting units 936 are arranged spaced apart from each other. In the second column, the light emitting unit 936 is arranged at the position corresponding to the space between the light emitting units 936 in the first column. Also in the row direction, multiple light emitting units 936 are arranged spaced apart from each other. The arrangement of the light emitting units 936 shown in Fig. 15C can be referred to as, for example, an arrangement in a grid pattern, an arrangement in a staggered pattern, or an arrangement in a checkered pattern.

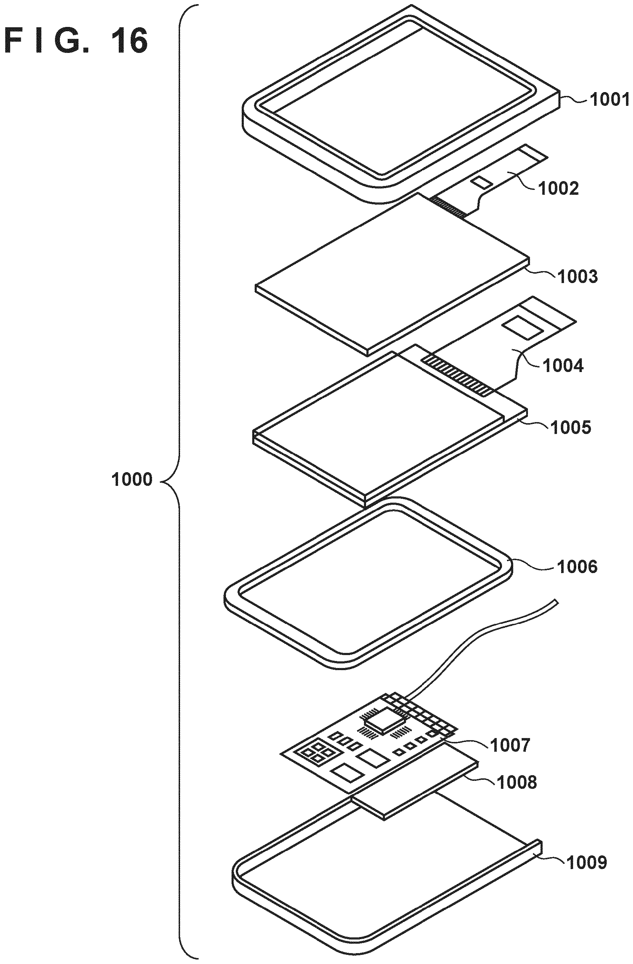

Fig. 16 is a schematic view showing an example of the display device using the semiconductor device 101 according to this embodiment. A display device 1000 can include a touch panel 1003, a display panel 1005, a frame 1006, a circuit board 1007, and a battery 1008 between an upper cover 1001 and a lower cover 1009. Flexible printed circuits (FPCs) 1002 and 1004 are respectively connected to the touch panel 1003 and the display panel 1005. Active elements such as transistors are arranged on the circuit board 1007. The battery 1008 is unnecessary if the display device 1000 is not a portable apparatus. Even when the display device 1000 is a portable apparatus, the battery 1008 need not be provided at this position. The semiconductor device 101 can be applied to the display panel 1005. The pixels 201 arranged in the pixel region 104 of the semiconductor device 101 functioning as the display panel 1005 operates in a state in which they are connected to the active elements such as transistors arranged on the circuit board 1007.

The display device 1000 shown in Fig. 16 can be used for a display unit of a photoelectric conversion device (also referred to as an image capturing device) including an optical unit having a plurality of lenses, and an image sensor for receiving light having passed through the optical unit and photoelectrically converting the light into an electric signal. The photoelectric conversion device can include a display unit for displaying information acquired by the image sensor. In addition, the display unit can be either a display unit exposed outside the photoelectric conversion device, or a display unit arranged in the finder. The photoelectric conversion device can be a digital camera or a digital video camera.

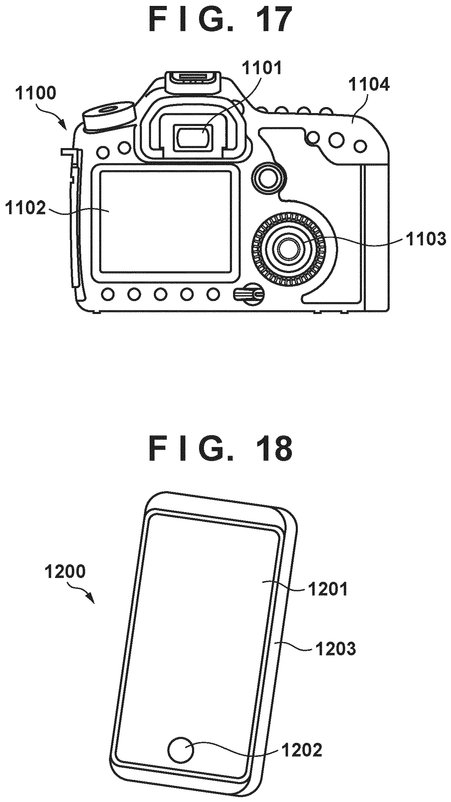

Fig. 17 is a schematic view showing an example of the photoelectric conversion device using the semiconductor device 101 according to this embodiment. A photoelectric conversion device 1100 can include a viewfinder 1101, a rear display 1102, an operation unit 1103, and a housing 1104. The photoelectric conversion device 1100 can also be called an image capturing device. The semiconductor device 101 according to this embodiment can be applied to the viewfinder 1101 or the rear display 1102 as a display unit. In this case, the pixel region 104 of the semiconductor device 101 can display not only an image to be captured but also environment information, image capturing instructions, and the like. Examples of the environment information are the intensity and direction of external light, the moving velocity of an object, and the possibility that an object is covered with an obstacle.

The timing suitable for image capturing is a very short time in many cases, so the information should be displayed as soon as possible. Therefore, the semiconductor device 101 in which the pixel 201 including the light emitting element using the organic light emitting material such as an organic EL element is arranged in the pixel region 104 may be used for the viewfinder 1101 or the rear display 1102. This is so because the organic light emitting material has a high response speed. The semiconductor device 101 using the organic light emitting material can be used for the devices that require a high display speed more suitably than for the liquid crystal display device.

The photoelectric conversion device 1100 includes an optical unit (not shown). This optical unit has a plurality of lenses, and forms an image on a photoelectric conversion element (not shown) that receives light having passed through the optical unit and is accommodated in the housing 1104. The focal points of the plurality of lenses can be adjusted by adjusting the relative positions. This operation can also automatically be performed.

The semiconductor device 101 may be applied to a display unit of an electronic apparatus. At this time, the display unit can have both a display function and an operation function. Examples of the portable terminal are a portable phone such as a smartphone, a tablet, and a head mounted display.

Fig. 18 is a schematic view showing an example of an electronic apparatus using the semiconductor device 101 according to this embodiment.

An electronic apparatus 1200 includes a display unit 1201, an operation unit 1202, and a housing 1203. The housing 1203 can accommodate a circuit, a printed board having this circuit, a battery, and a communication unit. The operation unit 1202 can be a button or a touch-panel-type reaction unit. The operation unit 1202 can also be a biometric authentication unit that performs unlocking or the like by authenticating the fingerprint. The portable apparatus including the communication unit can also be regarded as a communication apparatus. The semiconductor device 101 according to this embodiment can be applied to the display unit 1201.

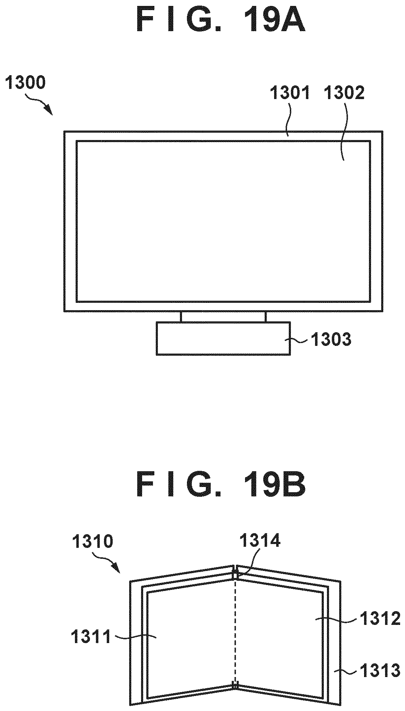

Figs. 19A and 19B are schematic views showing examples of the display device using the semiconductor device 101 according to this embodiment. Fig. 19A shows a display device such as a television monitor or a PC monitor. A display device 1300 includes a frame 1301 and a display unit 1302. The semiconductor device 101 according to this embodiment can be applied to the display unit 1302. The display device 1300 can include a base 1303 that supports the frame 1301 and the display unit 1302. The base 1303 is not limited to the form shown in Fig. 19A. For example, the lower side of the frame 1301 may also function as the base 1303. In addition, the frame 1301 and the display unit 1302 can be bent. The radius of curvature in this case can be 5,000 mm (inclusive) to 6,000 mm (inclusive).

Fig. 19B is a schematic view showing another example of the display device using the semiconductor device 101 according to this embodiment. A display device 1310 shown in Fig. 19B can be folded, and is a so-called foldable display device. The display device 1310 includes a first display unit 1311, a second display unit 1312, a housing 1313, and a bending point 1314. The semiconductor device 101 according to this embodiment can be applied to each of the first display unit 1311 and the second display unit 1312. The first display unit 1311 and the second display unit 1312 can also be one seamless display device. The first display unit 1311 and the second display unit 1312 can be divided by the bending point. The first display unit 1311 and the second display unit 1312 can display different images, and can also display one image together.

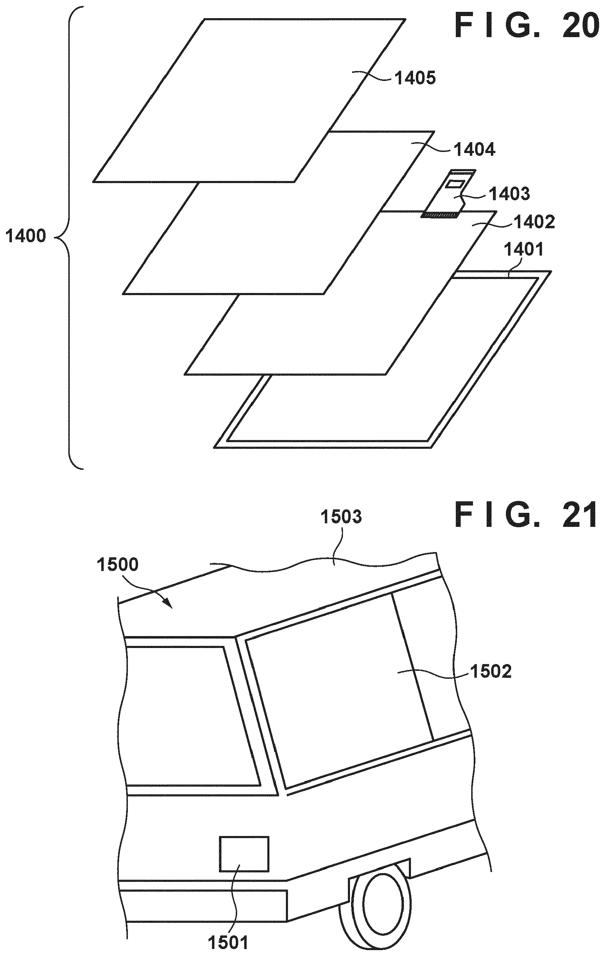

Fig. 20 is a schematic view showing an example of an illumination device using the semiconductor device 101 according to this embodiment. An illumination device 1400 may include a housing 1401, a light source 1402, a circuit board 1403, an optical film 1404, and a light diffusion unit 1405. The semiconductor device 101 according to this embodiment can be applied to the light source 1402. The optical film 1404 may be a filter that improves the color rendering property of the light source. The light diffusion unit 1405 can effectively diffuse light from the light source to illuminate a wide range for lighting up or the like. A cover may be provided in the outermost portion, as needed. The illumination device 1400 may include both the optical film 1404 and the light diffusion unit 1405, or may include only one of them.

The illumination device 1400 is, for example, a device that illuminates a room. The illumination device 1400 may emit light of white, day white, or any other color from blue to red. The illumination device 1400 may include a light control circuit for controlling the light color. The illumination device 1400 may include a power supply circuit connected to the pixel region 104 of the semiconductor device 101 which functions as the light source 1402. The power supply circuit is a circuit that converts an AC voltage into a DC voltage. Note that white light has a color temperature of 4200K, and day-white light has a color temperature of 5000K. The illumination device 1400 may also include a color filter. Further, the illumination device 1400 may include a heat dissipation portion. The heat dissipation portion releases the heat in the device to the outside of the device, and examples thereof include a metal having high specific heat, liquid silicon, and the like.

Fig. 21 is a schematic view showing an automobile including a tail lamp which is an example of the lighting unit for an automobile using the semiconductor device 101 according to this embodiment. An automobile 1500 includes a tail lamp 1501, and may turn on the tail lamp 1501 when a brake operation or the like is performed. The semiconductor device 101 according to this embodiment may be used in a head lamp as the lighting unit for an automobile. The automobile is an example of a moving body, and the moving body may be a ship, a drone, an aircraft, a railroad car, an industrial robot, or the like. The moving body may include a body and a lighting unit provided in the body. The lighting unit may inform the current position of the body.

The semiconductor device 101 according to this embodiment can be applied to the tail lamp 1501. The tail lamp 1501 may include a protective member that protects the semiconductor device 101 which functions as the tail lamp 1501. The protective member has a certain degree of strength, and can be made from any material as long as it is transparent. The protective member may be made from polycarbonate or the like. Further, the protective member may be made from polycarbonate mixed with furandicarboxylic acid derivative, acrylonitrile derivative, or the like.

The automobile 1500 may include a body 1503 and windows 1502 attached thereto. The window may be a window for checking the front or rear of the automobile, or may a transparent display such as a head-up display. The semiconductor device 101 according to this embodiment may be used in the transparent display. In this case, the components such as the electrodes included in the semiconductor device 101 are formed by transparent members.

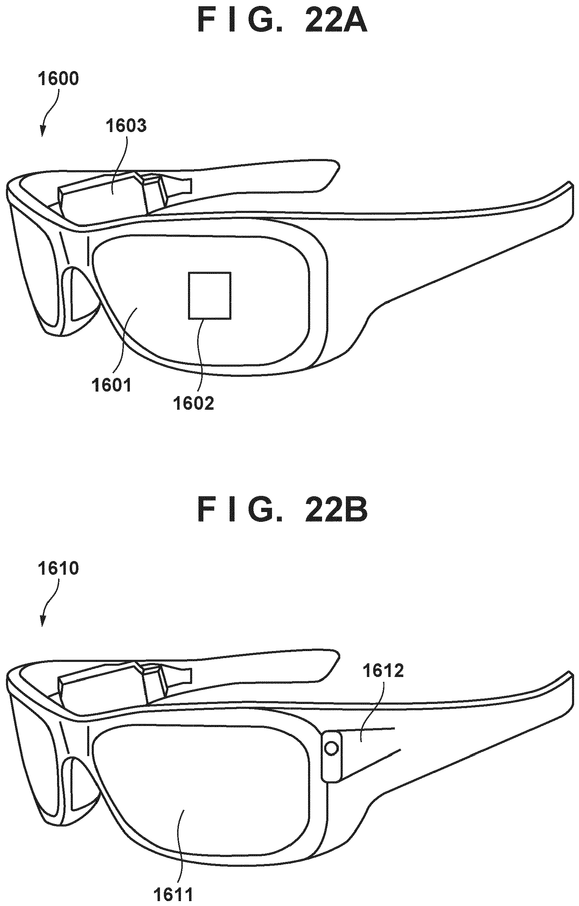

Further application examples of the semiconductor device 101 according to this embodiment will be described with reference to Figs. 22A and 22B. The semiconductor device 101 can be applied to a system that can be worn as a wearable device such as smartglasses, a Head Mounted Display (HMD), or a smart contact lens. An image capturing display device used for such application examples includes an image capturing device capable of photoelectrically converting visible light and a light emitting device capable of emitting visible light.

Glasses 1600 (smartglasses) according to one application example will be described with reference to Fig. 22A. An image capturing device 1602 such as a CMOS sensor or an SPAD is provided on the surface side of a lens 1601 of the glasses 1600. In addition, the semiconductor device 101 according to this embodiment is provided on the back surface side of the lens 1601.

The glasses 1600 further include a control device 1603. The control device 1603 functions as a power supply that supplies electric power to the image capturing device 1602 and the semiconductor device 101 according to each embodiment. In addition, the control device 1603 controls the operations of the image capturing device 1602 and the semiconductor device 101. An optical system configured to condense light to the image capturing device 1602 is formed on the lens 1601.

Glasses 1610 (smartglasses) according to one application example will be described with reference to Fig. 22B. The glasses 1610 include a control device 1612, and an image capturing device corresponding to the image capturing device 1602 and the semiconductor device 101 are mounted on the control device 1612. The image capturing device in the control device 1612 and an optical system configured to project light emitted from the semiconductor device 101 are formed in a lens 1611, and an image is projected to the lens 1611. The control device 1612 functions as a power supply that supplies electric power to the image capturing device and the semiconductor device 101, and controls the operations of the image capturing device and the semiconductor device 101. The control device 1612 may include a line-of-sight detection unit that detects the line of sight of a wearer. The detection of a line of sight may be done using infrared rays. An infrared ray emitting unit emits infrared rays to an eyeball of the user who is gazing at a displayed image. An image capturing unit including a light receiving element detects reflected light of the emitted infrared rays from the eyeball, thereby obtaining a captured image of the eyeball. A reduction unit for reducing light from the infrared ray emitting unit to the display unit in the planar view is provided, thereby reducing deterioration of image quality.

The line of sight of the user to the displayed image is detected from the captured image of the eyeball obtained by capturing the infrared rays. An arbitrary known method can be applied to the line-of-sight detection using the captured image of the eyeball. As an example, a line-of-sight detection method based on a Purkinje image obtained by reflection of irradiation light by a cornea can be used.

More specifically, line-of-sight detection processing based on pupil center corneal reflection is performed. Using pupil center corneal reflection, a line-of-sight vector representing the direction (rotation angle) of the eyeball is calculated based on the image of the pupil and the Purkinje image included in the captured image of the eyeball, thereby detecting the line-of-sight of the user.

The semiconductor device 101 according to the embodiment of the present disclosure can include an image capturing device including a light receiving element, and control a displayed image based on the line-of-sight information of the user from the image capturing device.

More specifically, the semiconductor device 101 decides a first visual field region at which the user is gazing and a second visual field region other than the first visual field region based on the line-of-sight information. The first visual field region and the second visual field region may be decided by the control device of the semiconductor device 101, or those decided by an external control device may be received. In the display region of the semiconductor device 101, the display resolution of the first visual field region may be controlled to be higher than the display resolution of the second visual field region. That is, the resolution of the second visual field region may be lower than that of the first visual field region.

In addition, the display region includes a first display region and a second display region different from the first display region, and a region of higher priority is decided from the first display region and the second display region based on line-of-sight information. The first display region and the second display region may be decided by the control device of the semiconductor device 101, or those decided by an external control device may be received. The resolution of the region of higher priority may be controlled to be higher than the resolution of the region other than the region of higher priority. That is, the resolution of the region of relatively low priority may be low.

Note that AI may be used to decide the first visual field region or the region of higher priority. The AI may be a model configured to estimate the angle of the line of sight and the distance to a target ahead the line of sight from the image of the eyeball using the image of the eyeball and the direction of actual viewing of the eyeball in the image as supervised data. The AI program may be held by the semiconductor device 101, the image capturing device, or an external device. If the external device holds the AI program, it is transmitted to the semiconductor device 101 via communication.

When performing display control based on line-of-sight detection, smartglasses further including an image capturing device configured to capture the outside can be applied. The smartglasses can display captured outside information in real time.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

A semiconductor device (101) that comprises, on a substrate (100), a pixel region (104) where a plurality of pixels (201) are arranged, and a monitor region (106) is provided. In the pixel region (104), a plurality of lenses (212) are arranged on an underlayer (309) such that the underlayer (309) is not exposed, and in the monitor region (106), a plurality of monitor lenses (222) are arranged on the underlayer (309). The plurality of monitor lenses (222) include a pair of monitor lenses arranged such that the underlayer (309) is not exposed between two monitor lenses (222) adjacent to each other, and a pair of monitor lenses arranged with an exposed portion (319) where the underlayer (309) is exposed between two monitor lenses (222) adjacent to each other.

## Claims

1. A semiconductor device (101) that comprises, on a substrate (100), a pixel region (104) where a plurality of pixels (201) are arranged, and a monitor region (106), the device **characterized in that**
in the pixel region (104), a plurality of lenses (212) are arranged on an underlayer (309) such that the underlayer (309) is not exposed,
in the monitor region (106), a plurality of monitor lenses (222) are arranged on the underlayer (309), and
the plurality of monitor lenses (222) include a pair of monitor lenses arranged such that the underlayer (309) is not exposed between two monitor lenses (222) adjacent to each other, and a pair of monitor lenses arranged with an exposed portion (319) where the underlayer (309) is exposed between two monitor lenses (222) adjacent to each other.

2. The semiconductor device according to claim 1, **characterized in that**
the plurality of lenses in the pixel region are arranged at a predetermined pitch, and
an arranging interval of two monitor lenses, among the plurality of monitor lenses, adjacent to each other arranged such that the underlayer is not exposed is equal to the predetermined pitch.

3. The semiconductor device according to claim 2, **characterized in that**
an arranging interval of two monitor lenses, among the plurality of monitor lenses, adjacent to each other via the exposed portion is larger than the predetermined pitch.

4. The semiconductor device according to claim 2, **characterized in that**
an arranging interval of two monitor lenses, among the plurality of monitor lenses, adjacent to each other via the exposed portion is equal to the predetermined pitch.

5. The semiconductor device according to claim 4, **characterized in that**
two monitor lenses, among the plurality of monitor lenses, adjacent to each other via the exposed portion include a first monitor lens which is in contact with one of the plurality of monitor lenses, and a second monitor lens which is not in contact with any other monitor lens of the plurality of monitor lenses, and
in a planar view, a diameter of the second monitor lens is smaller than a diameter of each of two monitor lenses, among the plurality of monitor lenses, adjacent to each other arranged such that the underlayer is not exposed.

6. The semiconductor device according to claim 5, **characterized in that**
a height of the second monitor lens from the underlayer is larger than a height of the first monitor lens from the underlayer.

7. The semiconductor device according to claim 5 or 6, **characterized in that**
a top of the second monitor lens is flatter than a top of the first monitor lens.

8. The semiconductor device according to any one of claims 1 to 7, **characterized in that**
a resin layer, which is not in contact with the plurality of monitor lenses and has a flat top, is arranged in the monitor region, and
the resin layer is formed of the same material as the plurality of lenses.

9. The semiconductor device according to any one of claims 1 to 8, **characterized in that**
the plurality of monitor lenses include a monitor lens not in contact with the exposed portion.

10. The semiconductor device according to any one of claims 1 to 9, **characterized by** further including a dummy pixel region where a dummy pixel is arranged on the substrate so as to be adjacent to the pixel region,
wherein the monitor region is arranged in the dummy pixel region.

11. The semiconductor device according to any one of claims 1 to 10, **characterized in that**
a color filter layer is arranged between the substrate and the plurality of monitor lenses.

12. The semiconductor device according to claim 11, **characterized in that** the underlayer includes the color filter layer.

13. The semiconductor device according to any one of claims 1 to 11, **characterized in that**
the underlayer includes a planarizing layer used to planarize a surface of a layer below the underlayer.

14. The semiconductor device according to any one of claims 1 to 13, **characterized in that**
at least one of the plurality of pixels each include a photoelectric conversion element.

15. The semiconductor device according to any one of claims 1 to 13, **characterized in that**
at least one of the plurality of pixels each include a light emitting element.

16. A display device **characterized by** comprising a semiconductor device defined in claim 15, and an active element connected to the semiconductor device.

17. A photoelectric conversion device **characterized by** comprising an optical unit including a plurality of lenses, an image sensor configured to receive light having passed through the optical unit, and a display unit configured to display an image,
wherein the display unit displays an image captured by the image sensor, and includes a semiconductor device defined in claim 15.

18. An electronic apparatus **characterized by** comprising a housing provided with a display unit, and a communication unit provided in the housing and configured to perform external communication,
wherein the display unit includes a semiconductor device defined in claim 15.

19. An illumination device **characterized by** comprising a light source, and at least one of a light diffusing unit and an optical film,
wherein the light source includes a semiconductor device defined in claim 15.

20. A moving body **characterized by** comprising a main body, and a lighting appliance provided in the main body,
wherein the lighting appliance includes a semiconductor device defined in claim 15.

21. A wearable device **characterized by** comprising a display device configured to display an image,
wherein the display device includes a semiconductor device defined in claim 15.

22. A manufacturing method of a semiconductor device (101) that comprises, on a substrate (100), a pixel region (104) where a plurality of pixels (201) are arranged, and a monitor region (106), the method **characterized in that**
in the pixel region (104), a plurality of lenses (212) are arranged on an underlayer (309) such that the underlayer (309) is not exposed,
in the monitor region (106), a plurality of monitor lenses (222) are arranged on the underlayer (309),
the method comprises forming the plurality of monitor lenses (222),
a mask pattern used to form the plurality of monitor lenses (222) includes the same mask pattern as a mask pattern used to form the plurality of lenses (212), and
the plurality of monitor lenses (222) include a pair of monitor lenses arranged such that the underlayer (309) is not exposed between two monitor lenses (222) adjacent to each other, and a pair of monitor lenses arranged with an exposed portion (319) where the underlayer (309) is exposed between two monitor lenses (222) adjacent to each other.
